# EUROPEAN PATENT SPECIFICATION

(11) **EP 3 783 852 B1**
(45) Date of publication and mention of the grant of the patent: **16.10.2024**
(21) Application number: 18921141.0
(22) Date of filing: 28.05.2018
(51) Int. Cl.: H03F 1/32, H03F 3/189, H04L 27/10

(54) **SIGNAL PROCESSING DEVICE AND SIGNAL PROCESSING METHOD**
SIGNALVERARBEITUNGSVORRICHTUNG UND SIGNALVERARBEITUNGSVERFAHREN
DISPOSITIF ET PROCÉDÉ DE TRAITEMENT DE SIGNAUX

(43) Date of publication of application: 24.02.2021
(73) Proprietor: HUAWEI TECHNOLOGIES CO., LTD., Shenzhen, Guangdong 518129 (CN)
(72) Inventor: WANG, Junpeng, Shenzhen, Guangdong 518129 (CN); JI, Tengteng, Shenzhen, Guangdong 518129 (CN); XUE, Yugui, Shenzhen, Guangdong 518129 (CN); CUI, Caixia, Shenzhen, Guangdong 518129 (CN)
(74) Representative: Gill Jennings & Every LLP
(86) International application number: PCT/CN2018/088759
(87) International publication number: WO 2019/227295

(56) References cited:
- EP-A1- 0 930 699
- EP-A1- 0 982 851
- EP-A2- 0 984 554
- WO-A1-99/27645
- CN-A- 1 336 722
- CN-A- 1 390 022
- CN-A- 101 170 334
- CN-A- 106 877 893
- US-A1- 2009 181 633

## Description

### TECHNICAL FIELD

This application relates to the field of communications technologies, and in particular, to a signal processing apparatus and a signal processing method.

### BACKGROUND

With continuous development of modern microwave communications technologies, communications environments become increasingly complex, and a possibility of interference between signals becomes increasingly higher.

When an interfering signal interacts with a wanted signal, a non-linear intermodulation product is generated. If the non-linear intermodulation product falls within a frequency band range of the wanted signal, and is in a same band with the signal, a filter commonly used for filtering out the interfering signal cannot filter out the non-linear intermodulation product, and the non-linear intermodulation product always affects quality of the wanted signal.

Therefore, how to perform effective anti-interference processing on the non-linear intermodulation product becomes a hot research subject.

EP0982851 relates to a linear amplifier arrangement. US 2009/0181633 relates to receiver second order intermodulation correction system and method.

### SUMMARY

This application provides a signal processing apparatus and method, to resolve a problem of how to perform effective anti-interference processing on a non-linear intermodulation product.

The invention has been defined in the independent claims. Further specific technical features have been defined in the dependent claims.

### BRIEF DESCRIPTION OF DRAWINGS

FIG. 1 is a schematic structural diagram of a signal processing apparatus according to an implementation of this application;
FIG. 2 is a spectrum graph of an output signal according to an implementation of this application;
FIG. 3 is a schematic structural diagram of a signal processing apparatus according to an implementation of this application;
FIG. 4a is a schematic structural diagram of a signal matching circuit according to an implementation of this application;
FIG. 4b is a schematic structural diagram of another signal matching circuit according to an implementation of this application;
FIG. 4c is a schematic structural diagram of still another signal matching circuit according to an implementation of this application;
FIG. 4d is a schematic structural diagram of yet another signal matching circuit according to an implementation of this application;
FIG. 5 is a schematic structural diagram of a first signal processing branch according to an implementation of this application;
FIG. 6 is a schematic structural diagram of a second signal processing branch according to an implementation of this application;
FIG. 7 is a schematic structural diagram of a digital processing circuit according to an implementation of this application;
FIG. 8 is a schematic structural diagram of another signal processing apparatus according to an implementation of this application; and
FIG. 9 is a schematic flowchart of a signal processing method according to an implementation of this application.

### DESCRIPTION OF IMPLEMENTATIONS

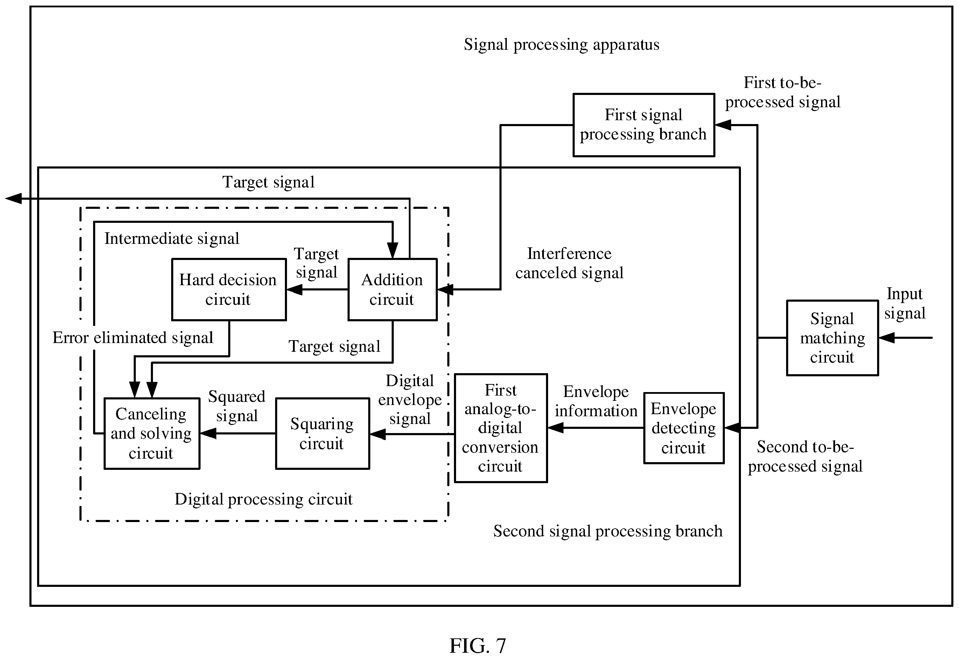

The invention made is described in the embodiments referring to figure 7.

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those which comprise at least all the features of an independent claim. Any implementation which does not fall within the scope of the claims does not form part of the invention, but rather included as an illustrative example that is useful for understanding the invention.

The following correspondingly describes the technical solutions in the implementations of this application with reference to the accompanying drawings in the implementations of this application.

With continuous development of modern microwave communications technologies, communications environments become increasingly complex, and frequencies of signals are increasingly higher. There may be a plurality of microwave devices on a same tower, and different microwave devices may use different frequencies. In a process of transmitting signals, there is a relatively high possibility that signals transmitted by different microwave devices interfere with each other. This affects stability of a communication channel. For example, in a propagation process of signals of two or more frequencies, a non-linear intermodulation product of another frequency may be generated. The non-linear intermodulation product overlaps a wanted signal, severely reducing signal quality.

The non-linear intermodulation product may have a third-order component, a fifth-order component, a seventh-order component, or even a component of a higher order. A component of a third-order intermodulation product is the largest. For example, if a frequency of a wanted signal is f1, a frequency of an interfering signal is f2 (f2>f1), and a frequency difference between the wanted signal and the interfering signal is Δf=f2-f1, a frequency of the third-order intermodulation product may be between f2+Δf and f1-Δf. When the third-order intermodulation product falls in a frequency range of the wanted signal, the wanted signal may be severely distorted.

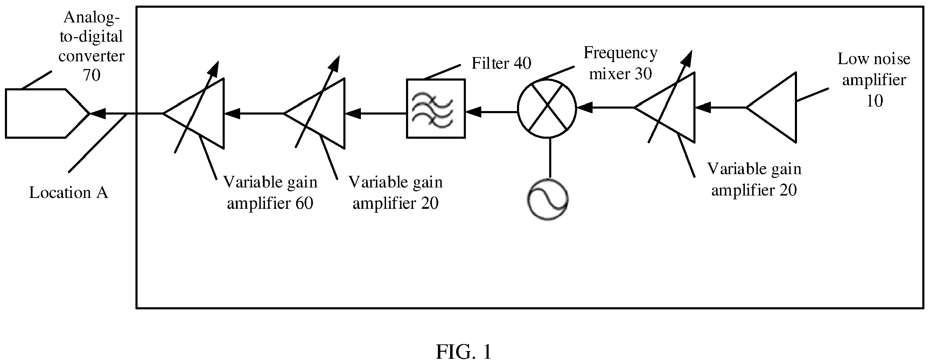

In an implementation, the interfering signal may be suppressed by a filter. For example, FIG. 1 is a schematic structural diagram of a signal processing apparatus according to this application. The apparatus shown in FIG. 1 may include: a low noise amplifier 10, a variable gain amplifier 20, a frequency mixer 30, a filter 40, a variable gain amplifier 50, a variable gain amplifier 60, and an analog-to-digital converter 70.

Specifically, after an input signal is input to the low noise amplifier 10 for amplification, downconversion of the signal may be implemented by the frequency mixer 30; and after the signal is filtered by the filter 40, power of the signal may be adjusted by the variable gain amplifier 50 and the variable gain amplifier 60, and then the signal is input to the analog-to-digital converter 70, so that a next device performs digital processing on the signal in a digital domain.

However, a signal amplitude of an interfering signal input to the low noise amplifier 10 is usually relatively large, the interfering signal and a wanted signal may affect each other in a previous device (for example, the frequency mixer 30) of the filter 40, and consequently, a non-linear intermodulation product is generated. The non-linear intermodulation product falls in a frequency band range of the wanted signal, and is in a same band with the wanted signal.

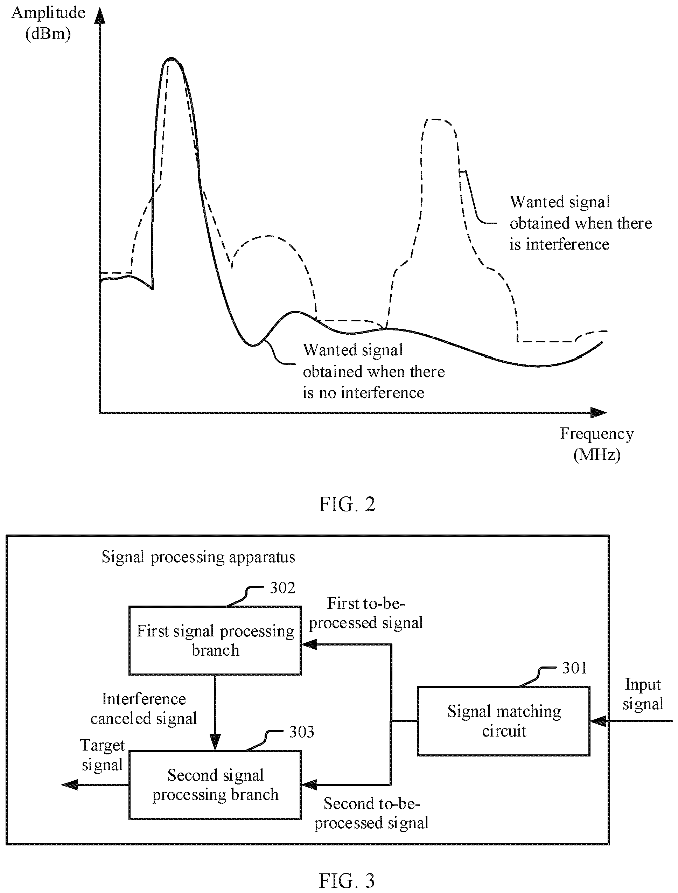

FIG. 2 is a spectrum graph of an output signal obtained through measurement at a location A (that is, a location between the variable gain amplifier 60 and the analog-to-digital converter 70) in FIG. 1. A solid line represents a wanted signal collected at the location A when there is no interference, and a dashed line represents a wanted signal collected at the location A when there is an interfering signal. It can be learned that, when there is the interfering signal, due to a non-linear characteristic of an analog receive channel, a non-linear intermodulation product is generated by using the interfering signal and the wanted signal. The non-linear intermodulation product may fall in a frequency band range of the wanted signal, and the non-linear intermodulation product cannot be suppressed by the filter 40. Due to frequency selectivity of the filter 40, the interfering signal is suppressed when passing through the filter 40, and power of the interfering signal approximates to that of the wanted signal. Actually, the power of the interfering signal input to the low noise amplifier 10 is far greater than that of the wanted signal.

It can be learned that, the filter cannot perform effective anti-interference processing on a signal, and a filtered signal is still relatively severely distorted.

To resolve the foregoing technical problem, this application further provides a signal processing apparatus, to resolve a problem that in a radio frequency communications system, a non-linear intermodulation product deteriorates signal quality when there is interference on a communications channel.

For ease of understanding, a main inventive principle of this application may include: A signal processing branch is disposed before a filter to collect envelope information of an interfering signal (in this case, the interfering signal is not suppressed by the filter, and the collected envelope information can be effectively used for subsequent digital sampling); then a signal used to cancel out a non-linear intermodulation product is constructed in a digital domain based on the envelope information; and the signal is synthesized with a signal filtered by the filter, to cancel out the non-linear intermodulation product, thereby improving signal quality.

It should be noted that, the foregoing principle is merely used for explanation, and should not constitute a limitation on this application.

Based on the foregoing main inventive principle, FIG. 3 is a schematic structural diagram of another signal processing apparatus according to an implementation of this application. It can be learned that, the signal processing apparatus in FIG. 3 may include: a signal matching circuit 301, a first signal processing branch 302, and a second signal processing branch 303.

In an implementation, the signal processing apparatus may be disposed in a receive link of a microwave out door communications unit (Out Door Unit, ODU), or a receive link of a full out door communications unit (Full Out Door Unit, Full-ODU). This is not limited in this application.

An output end of the signal matching circuit 301 is separately coupled to an input end of the first signal processing branch 302 and an input end of the second signal processing branch 303, and an output end of the first signal processing branch 302 is coupled to the input end of the second signal processing branch 303.

The signal matching circuit 301 may be configured to: separately obtain a first to-be-processed signal and a second to-be-processed signal based on an input signal, input the first to-be-processed signal to the first signal processing branch 302, and input the second to-be-processed signal to the second signal processing branch 303.

In an implementation, the input signal may be input by a previous device connected to the signal processing apparatus, and the input signal may include a wanted signal and an interfering signal, or may further include a non-linear intermodulation product generated when the wanted signal and the interfering signal affect each other.

In an implementation, signal strength of the interfering signal may be far greater than signal strength of the wanted signal, or a frequency of the interfering signal may be far higher than a frequency of the wanted signal, or an amplitude of the interfering signal may be far larger than an amplitude of the wanted signal, or there may be another case. This is not limited in this application.

A coupling circuit may be disposed in the signal matching circuit 301. The signal is divided into two signals through the coupling circuit, and the two signals are respectively input to the first signal processing branch 302 for filtering processing and the second signal processing branch 303 for collecting envelope information.

In an implementation, the signal matching circuit may include: a frequency mixing circuit, a signal amplification circuit, and the coupling circuit. An output end of the signal amplification circuit is coupled to an input end of the frequency mixing circuit, an output end of the frequency mixing circuit is coupled to an input end of the coupling circuit, and an output end of the coupling circuit is separately coupled to the input end of the first signal processing branch and the input end of the second signal processing branch.

The signal amplification circuit is configured to amplify the input signal, to obtain an amplified signal; and input the amplified signal to the frequency mixing circuit. The frequency mixing circuit is configured to adjust a frequency of the amplified signal to a preset frequency range, to obtain a mixed signal; and input the mixed signal to the coupling circuit. The coupling circuit is configured to: couple the mixed signal, to separately obtain the first to-be-processed signal and the second to-be-processed signal; input the first to-be-processed signal to the first signal processing branch; and input the second to-be-processed signal to the second signal processing branch.

In an implementation, alternatively, the output end of the signal amplification circuit may be coupled to the input end of the coupling circuit, the output end of the coupling circuit is separately coupled to the input end of the second signal processing branch and the input end of the frequency mixing circuit, and the output end of the frequency mixing circuit is coupled to the input end of the first signal processing branch.

The signal amplification circuit is configured to amplify the input signal, to obtain an amplified signal; and input the amplified signal to the coupling circuit. The coupling circuit is configured to couple the amplified signal, to obtain the second to-be-processed signal; and separately input the second to-be-processed signal to the second signal processing branch and the frequency mixing circuit. The frequency mixing circuit is configured to adjust a frequency of the second to-be-processed signal to a preset frequency range, to obtain the first to-be-processed signal; and input the first to-be-processed signal to the first signal processing branch.

In an implementation, alternatively, the output end of the coupling circuit may be separately coupled to the input end of the second signal processing branch and the input end of the signal amplification circuit, the output end of the signal amplification circuit is coupled to the input end of the frequency mixing circuit, and the output end of the frequency mixing circuit is coupled to the first signal processing branch.

The coupling circuit is configured to couple the input signal, to obtain the second to-be-processed signal; and separately input the second to-be-processed signal to the second signal processing branch and the signal amplification circuit. The signal amplification circuit is configured to amplify the second to-be-processed signal, to obtain an amplified signal; and input the amplified signal to the frequency mixing circuit. The frequency mixing circuit is configured to adjust a frequency of the amplified signal to a preset frequency range, to obtain the first to-be-processed signal; and input the first to-be-processed signal to the first signal processing branch.

In an implementation, the signal matching circuit may alternatively include: a frequency mixing circuit, a signal amplification circuit, a second power adjustment circuit, and a coupling circuit.

The signal amplification circuit described in this application may be a low noise amplifier (Low Noise Amplifier, LNA), so that the input signal is amplified while a relatively low noise factor is ensured. Because all subsequent circuits process the amplified signal passing through the signal amplification circuit, disposing an LNA with a low noise factor can ensure that a subsequent processing process is not affected by noise of the amplifier.

Alternatively, the signal amplification circuit described in this application may be a power amplifier (Power Amplifier, PA), a fiber amplifier (Fiber Amplifier, FA), a line amplifier (Line-Amplifier, LA), or the like. This is not limited in this application.

The second power adjustment circuit described in this application may be a variable gain amplifier (Variable Gain Amplifier, VGA), a variable voltage amplifier (Variable Voltage Amplifier, WA), or a combination of the WA and an amplifier. This is not limited in this application.

A core device of the frequency mixing circuit described in this application may be a frequency mixer, to implement frequency transformation. The frequency mixing circuit may be a single frequency conversion architecture, and only include one stage of frequency mixer; or is a super-heterodyne architecture, and includes a plurality of stages of frequency mixers; or there may be another case. This is not limited in this application.

The frequency mixer may directly process the amplified signal (which is a radio frequency signal) amplified by the signal amplification circuit, and perform frequency conversion on the amplified signal, to obtain the mixed signal. The frequency mixer may alternatively receive a local oscillation (Local Oscillation, LO) signal from a voltage-controlled oscillator, to implement a frequency mixing function.

The coupling circuit described in this application may be a coupler, a power splitter, or the like.

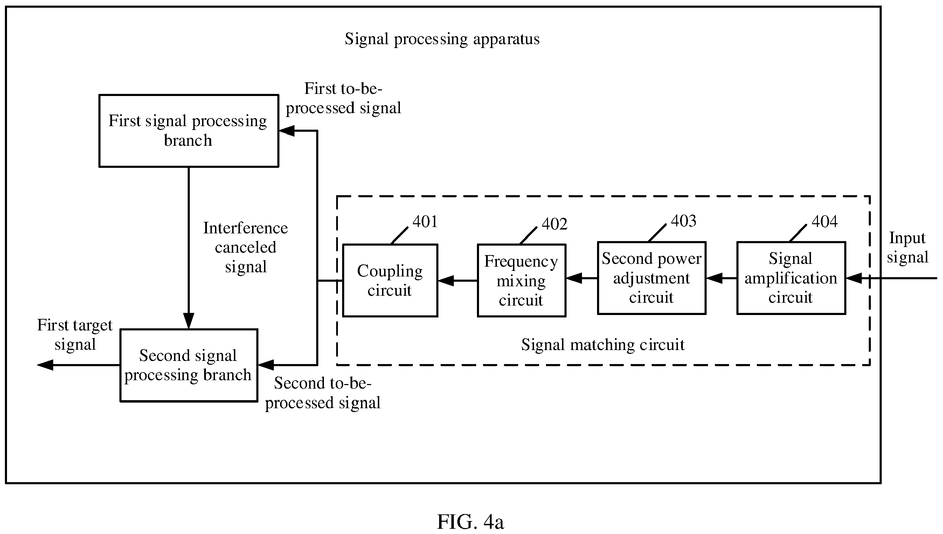

In an implementation, FIG. 4a is a schematic structural diagram of a signal matching circuit according to this application. The signal matching circuit shown in FIG. 4a may include: a frequency mixing circuit 402, a signal amplification circuit 404, a second power adjustment circuit 403, and a coupling circuit 401. An output end of the signal amplification circuit 404 is coupled to an input end of the second power adjustment circuit 403, an output end of the second power adjustment circuit 403 is coupled to an input end of the frequency mixing circuit 402, an output end of the frequency mixing circuit 402 is coupled to an input end of the coupling circuit 401, and an output end of the coupling circuit 401 is separately coupled to the input end of the first signal processing branch and the input end of the second signal processing branch.

The signal amplification circuit 404 may be configured to amplify the input signal, to obtain an amplified signal; and input the amplified signal to the second power adjustment circuit 403.

The second power adjustment circuit 403 is configured to perform power adjustment processing on the amplified signal and input the amplified signal obtained after the power adjustment processing to the frequency mixing circuit 402. Specifically, the second power adjustment circuit 403 may perform power adjustment on the amplified signal, to ensure that power of the signal input to a next device is in a preset range, and that the signal can be processed by the lower-level device.

The frequency mixing circuit 402 may be configured to adjust a frequency of the amplified signal obtained after the power adjustment processing to a preset frequency range, to obtain a mixed signal; and input the mixed signal to the coupling circuit 401.

The coupling circuit 401 may be configured to couple the mixed signal, to separately obtain the first to-be-processed signal and the second to-be-processed signal; input the first to-be-processed signal to the first signal processing branch; and input the second to-be-processed signal to the second signal processing branch. The first to-be-processed signal and the second to-be-processed signal may be two same signals. After being coupled by the coupling circuit 401, the signal input to the coupling circuit 401 may be duplicated, to obtain the two same signals.

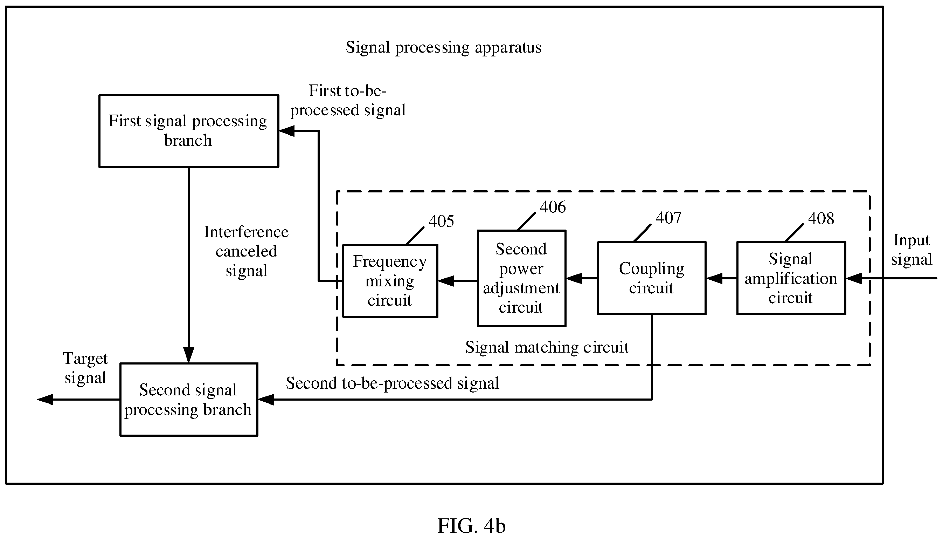

In another implementation, referring to FIG. 4b, a signal matching circuit may include: a frequency mixing circuit 405, a second power adjustment circuit 406, a coupling circuit 407, and a signal amplification circuit 408. An output end of the signal amplification circuit 408 is coupled to an input end of the coupling circuit 407, an output end of the coupling circuit 407 is separately coupled to the input end of the second signal processing branch and an input end of the second power adjustment circuit 406, an output end of the second power adjustment circuit 406 is coupled to an input end of the frequency mixing circuit 405, and an output end of the frequency mixing circuit 405 is coupled to the input end of the first signal processing branch.

The signal amplification circuit 408 may be configured to amplify the input signal, to obtain an amplified signal; and input the amplified signal to the coupling circuit 407.

The coupling circuit 407 may be configured to couple the amplified signal, to obtain the second to-be-processed signal; and separately input the second to-be-processed signal to the second power adjustment circuit 406 and the second signal processing branch.

The second power adjustment circuit 406 is configured to perform power adjustment processing on the second to-be-processed signal and input the second to-be-processed signal obtained after the power adjustment processing to the frequency mixing circuit 405.

The frequency mixing circuit 405 is configured to adjust a frequency of the second to-be-processed signal obtained after the power adjustment processing to a preset frequency range, to obtain the first to-be-processed signal; and input the first to-be-processed signal to the first signal processing branch.

It should be noted that, the first to-be-processed signal and the second to-be-processed signal that are generated by the signal matching circuit shown in FIG. 4b are different. The first to-be-processed signal is a signal obtained after the frequency mixing circuit 405 adjusts, after the power adjustment processing is performed on the second to-be-processed signal, the frequency of the second to-be-processed signal.

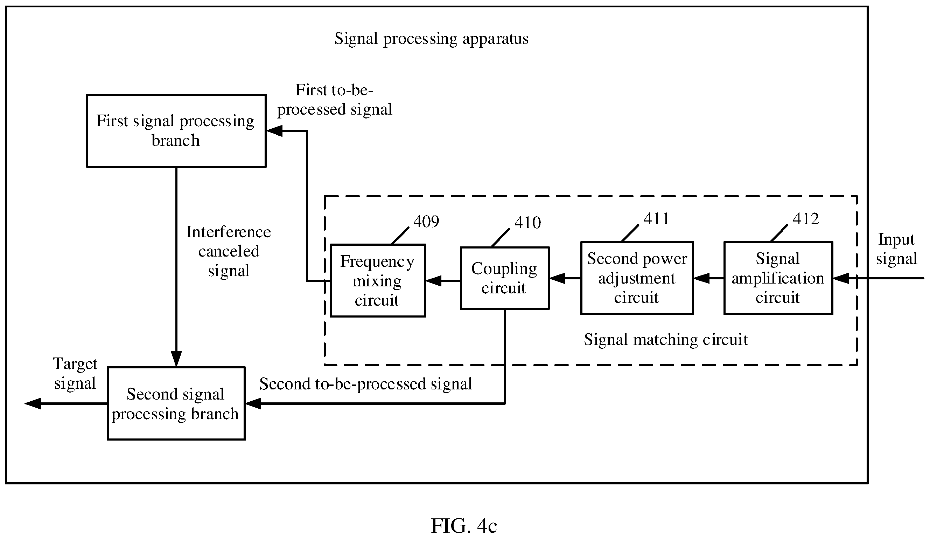

In still another implementation, referring to FIG. 4c, a signal matching circuit shown in FIG. 4c may include: a frequency mixing circuit 409, a signal amplification circuit 412, a second power adjustment circuit 411, and a coupling circuit 410.

An output end of the signal amplification circuit 412 is coupled to an input end of the second power adjustment circuit 411, an output end of the second power adjustment circuit 411 is coupled to an input end of the coupling circuit 410, an output end of the coupling circuit 410 is separately coupled to an input end of the frequency mixing circuit 409 and the input end of the second signal processing branch, and an output end of the frequency mixing circuit 409 is coupled to the input end of the first signal processing branch.

The signal amplification circuit 412 may be configured to amplify the input signal, to obtain an amplified signal; and input the amplified signal to the second power adjustment circuit 411.

The second power adjustment circuit 411 may be configured to perform power adjustment processing on the amplified signal and input the amplified signal obtained after the power adjustment processing to the coupling circuit 410.

The coupling circuit 410 may be configured to couple the amplified signal obtained after the power adjustment processing, to obtain the second to-be-processed signal; and separately input the second to-be-processed signal to the frequency mixing circuit 409 and the second signal processing branch.

The frequency mixing circuit 409 may be configured to adjust a frequency of the second to-be-processed signal to a preset frequency range, to obtain the first to-be-processed signal; and input the first to-be-processed signal to the first signal processing branch.

It should be noted that, the first to-be-processed signal and the second to-be-processed signal that are generated by the signal matching circuit shown in FIG. 4c are different. The first to-be-processed signal is a signal obtained after the frequency mixing circuit 410 adjusts the frequency of the second to-be-processed signal.

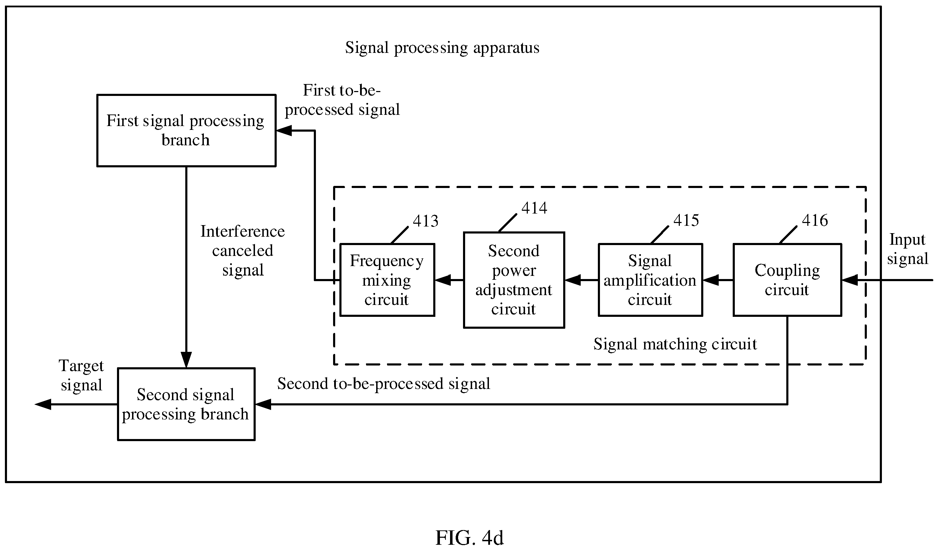

In still another implementation, referring to FIG. 4d, a signal matching circuit shown in FIG. 4d may include: a frequency mixing circuit 413, a signal amplification circuit 414, a second power adjustment circuit 415, and a coupling circuit 416. An output end of the coupling circuit 416 is separately coupled to the input end of the second signal processing branch and an input end of the signal amplification circuit 415, an output end of the signal amplification circuit 415 is coupled to an input end of the second power adjustment circuit 414, an output end of the second power adjustment circuit 414 is coupled to an input end of the frequency mixing circuit 413, and an output end of the frequency mixing circuit 413 is coupled to the input end of the first signal processing branch.

The coupling circuit 416 may be configured to couple the input signal, to obtain the second to-be-processed signal; and separately input the second to-be-processed signal to the second signal processing branch and the signal amplification circuit 415.

It should be noted that, the coupling circuit 416 couples the input signal, to obtain two same signals. That is, the two obtained second to-be-processed signals may be the same as the input signal.

The signal amplification circuit 415 may be configured to amplify the second to-be-processed signal, to obtain an amplified signal; and input the amplified signal to the second power adjustment circuit 414.

The second power adjustment circuit 414 may be configured to perform power adjustment processing on the amplified signal and input the amplified signal obtained after the power adjustment processing to the frequency mixing circuit 413.

The frequency mixing circuit 413 may be configured to adjust a frequency of the amplified signal obtained after the power adjustment processing to a preset frequency range, to obtain the first to-be-processed signal; and input the first to-be-processed signal to the first signal processing branch.

It should be noted that, the first to-be-processed signal and the second to-be-processed signal that are generated by the signal matching circuit shown in FIG. 4d are different. The second to-be-processed signal may be the same as the input signal, and the first to-be-processed signal may be a signal obtained after the signal amplification processing, the power adjustment processing, and the frequency mixing processing are performed on the second to-be-processed signal.

The first signal processing branch 302 may be configured to filter the first to-be-processed signal, to obtain an interference canceled signal; and input the interference canceled signal to the second signal processing branch 303, where the interference canceled signal includes a non-linear intermodulation product.

For example, the first to-be-processed signal may include the wanted signal, the interfering signal, and the non-linear intermodulation product. The first signal processing branch 302 filters the first to-be-processed signal, and filters out the interfering signal in a manner of frequency selection, to obtain the interference canceled signal including the non-linear intermodulation product.

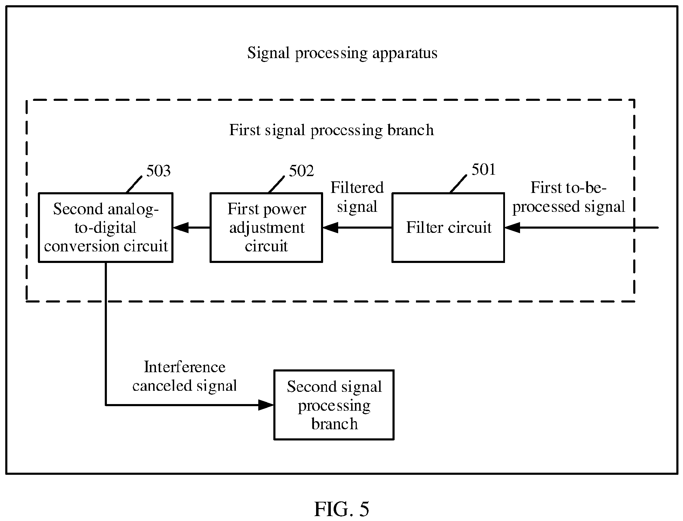

In an implementation, FIG. 5 is a schematic structural diagram of a first signal processing branch according to an implementation of this application. The first signal processing branch shown in FIG. 5 may include: a filter circuit 501, a first power adjustment circuit 502, and a second analog-to-digital conversion circuit 503. An input end of the filter circuit 501 is coupled to the output end of the signal matching circuit, an output end of the filter circuit 501 is coupled to an input end of the first power adjustment circuit 502, an output end of the first power adjustment circuit 502 is coupled to an input end of the second analog-to-digital conversion circuit 503, and an output end of the second analog-to-digital conversion circuit 503 is coupled to the input end of the second signal processing branch.

The filter circuit 501 may be configured to filter the first to-be-processed signal, to obtain a filtered signal; and input the filtered signal to the first power adjustment circuit 502.

In an implementation, the filter circuit 501 may be a filter, and specifically, may be a band-pass filter, a high-pass filter, a low-pass filter, a band-rejection filter, or the like. This is not limited in this application.

For example, a frequency selection range may be preset for the filter circuit 501. A frequency of the interfering signal is not in the frequency selection range. When the first to-be-processed signal is input, the filter circuit 501 may filter out the interfering signal based on the frequency selection range, to obtain the filtered signal that is filtered.

The first power adjustment circuit 502 is configured to perform power adjustment processing on the filtered signal and then input the filtered signal obtained after the power adjustment processing to the second analog-to-digital conversion circuit 503.

In an implementation, the first power adjustment circuit 502 may be a VGA.

In an implementation, one, two, or even more first power adjustment circuits 502 may be disposed. Gain adjustment is performed on the filtered signal through the plurality of first power adjustment circuits, to further adjust a signal level, thereby ensuring that the next device can work normally.

The second analog-to-digital conversion circuit 503 is configured to perform analog-to-digital conversion processing on the filtered signal obtained after the power adjustment processing, to obtain the interference canceled signal; and input the interference canceled signal to the second signal processing branch.

In an implementation, the second analog-to-digital conversion circuit 503 may be an ADC.

The second analog-to-digital conversion circuit 503 may convert the filtered signal from an analog signal into a digital signal, and the digital signal obtained through the conversion is the interference canceled signal.

The second signal processing branch 303 may be configured to collect envelope information in the second to-be-processed signal, and generate, based on the envelope information and the interference canceled signal, a target signal in which the non-linear intermodulation product is canceled out.

The second to-be-processed signal may include the wanted signal, the interfering signal, and the non-linear intermodulation product. The signal strength of the interfering signal may be far greater than the signal strength of the wanted signal. Therefore, the collected envelope information in the second to-be-processed signal may be approximately the same as envelope information of the interfering signal. The interfering signal before the filtering may be restored by using the envelope information of the interfering signal. Algorithm correction is performed through the interfering signal before the filtering, to calculate the generated non-linear intermodulation product, and an intermediate signal used to cancel out the non-linear intermodulation product is generated based on a calculation result. Then, the interference canceled signal is canceled out by using the intermediate signal, to obtain the target signal in which the non-linear intermodulation product is filtered out, so that a problem of signal distortion is alleviated.

It can be learned that, in this implementation of this application, the signal matching circuit performs preliminary processing on the input signal, to obtain the first to-be-processed signal and the second to-be-processed signal; and the first signal processing branch filters the first to-be-processed signal, to obtain interference canceled information. The second signal processing branch collects the envelope information in the second to-be-processed signal that is not filtered, and cancels out the non-linear intermodulation product canceledbased on the envelope information and the interference canceled signal, to obtain the target signal. In this way, effective anti-interference processing is performed on the non-linear intermodulation product to some extent, thereby improving signal quality.

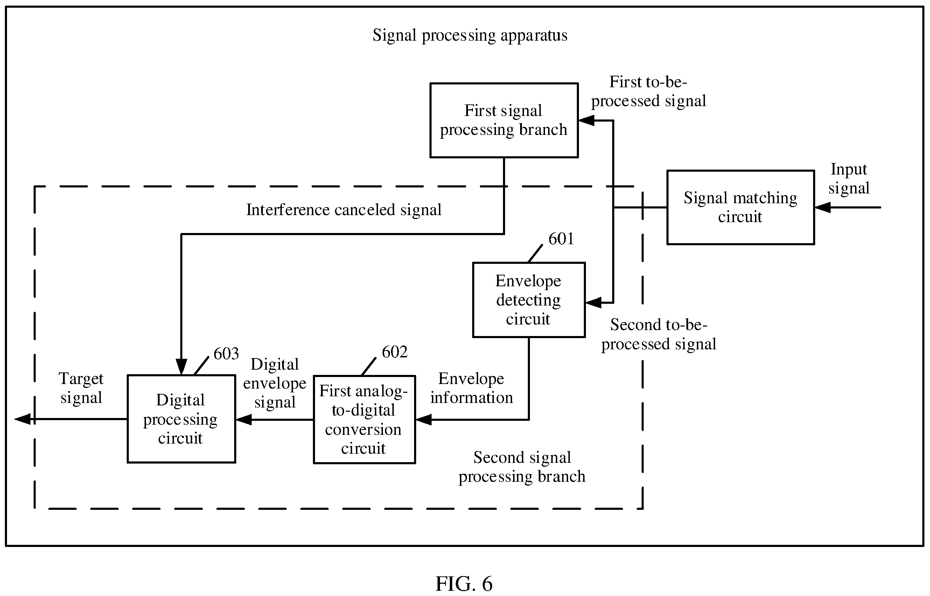

FIG. 6 is a schematic structural diagram of a second signal processing branch according to this application. The second signal processing branch shown in FIG. 6 may include: an envelope detecting circuit 601, a first analog-to-digital conversion circuit 602, and a digital processing circuit 603. The output end of the signal matching circuit is coupled to an input end of the envelope detecting circuit 601, an output end of the envelope detecting circuit 601 is coupled to an input end of the first analog-to-digital conversion circuit 602, and an output end of the first analog-to-digital conversion circuit 602 and the output end of the first signal processing branch are separately coupled to an input end of the digital processing circuit 603.

The envelope detecting circuit 601 is configured to collect the envelope information in the second to-be-processed signal, and input the envelope information to the first analog-to-digital conversion circuit 602.

In an implementation, the envelope detecting circuit 601 may be an envelope detecting tube. For example, the envelope detecting tube may perform signal information extraction on the second to-be-processed signal, to demodulate the second to-be-processed signal to obtain a low frequency signal, where the low frequency signal obtained through demodulation includes useful information (such as an amplitude) in the second to-be-processed signal. This process may be referred to as collecting the envelope information in the second to-be-processed signal.

The first analog-to-digital conversion circuit 602 is configured to perform first analog-to-digital conversion processing based on the envelope information, to obtain a digital envelope signal; and input the digital envelope signal to the digital processing circuit 603.

In an implementation, the first analog-to-digital conversion circuit 602 may be an ADC. For example, after the envelope detecting circuit inputs the envelope information to the ADC, the ADC may convert the envelope information from an analog domain to a digital domain, to obtain the digital envelope signal.

The digital processing circuit 603 is configured to obtain, based on the interference canceled signal and the digital envelope signal, the target signal in which the non-linear intermodulation product is canceled out.

In an implementation, the digital processing circuit 603 may be integrated in an American standard code for information interchange (American Standard Code for Information Interchange, ASCII) chip, a digital signal processing (Digital Signal Processing, DSP) chip, a field programmable gate array (Field-Programmable Gate Array, FPGA) chip, or the like, and is configured to obtain, based on the interference canceled signal and the digital envelope signal, the target signal in which the non-linear intermodulation product is canceled out.

In an implementation, FIG. 7 is a schematic structural diagram of a digital processing circuit according to this application. The digital processing circuit shown in FIG. 7 may specifically include: a squaring circuit 6031, a canceling and solving circuit 6032, an addition circuit 6033, and a hard decision circuit 6034. The output end of the first analog-to-digital conversion circuit is coupled to an input end of the squaring circuit 6031; an output end of the squaring circuit 6031, an output end of the hard decision circuit 6034, and an output end of the addition circuit 6033 are separately coupled to an input end of the canceling and solving circuit 6032; an output end of the canceling and solving circuit 6032 and the output end of the first signal processing branch are separately coupled to an input end of the addition circuit 6033; and the output end of the addition circuit 6033 is coupled to an input end of the hard decision circuit 6034.

The addition circuit 6033 is configured to separately input a target signal to the canceling and solving circuit 6032 and the hard decision circuit 6034.

It should be clarified that, a signal generated by the addition circuit 6033 is the target signal.

The hard decision circuit 6034 is configured to perform error eliminating processing on the target signal based on a preset threshold condition, to obtain an error eliminated signal; and input the error eliminated signal to the canceling and solving circuit 6032.

For example, the hard decision circuit may pre-estimate a point cloud diagram of an ideal signal (where the point cloud diagram includes amplitudes and phase relationships of all points in the estimated ideal signal). Distances between the points may be the same. The preset threshold may be a value obtained by dividing a distance between two adjacent points by 2. That is, the preset threshold may be a center value of a distance between two adjacent points. When the target signal is received, a point a in the target signal may be compared with a corresponding point a' in the estimated ideal signal. If a distance difference between the point a and the point a' is less than the preset threshold, it may be determined that the point a can represent the point a' in the ideal signal. If a distance difference between the point a and the point a' is greater than the preset threshold, it may be determined that the point a cannot represent the point a' in the ideal signal. Some errors may be eliminated by comparing all points in the target signal with corresponding points in the estimated ideal signal.

The squaring circuit 6031 is configured to square the digital envelope signal, to obtain a squared signal; and input the squared signal to the canceling and solving circuit 6032.

The canceling and solving circuit 6032 is configured to obtain, based on the squared signal, the target signal, and the error eliminated signal, the intermediate signal used to cancel out the non-linear intermodulation product; and input the intermediate signal to the addition circuit 6033.

In an implementation, the canceling and solving circuit 6032 is specifically configured to: multiply the squared signal by the error eliminated signal, to obtain a cancellation component used to cancel out the non-linear intermodulation product; perform error solving processing on the target signal and the error eliminated signal, to obtain a coefficient value of the cancellation component; and multiply the coefficient value of the cancellation component by the cancellation component, to obtain the intermediate signal used to cancel out the non-linear intermodulation product, and input the intermediate signal to the addition circuit 6033.

For example, the intermediate signal used to cancel out the non-linear intermodulation product may include two parts: the cancellation component and the coefficient value of the cancellation component. The cancellation component is obtained by multiplying a square (that is, the squared signal) of a modulus value of the digital envelope signal by a hard decision signal, and an error between the hard decision signal and the target signal before the hard decision is solved. Then the coefficient value of the cancellation component is solved based on the error between the hard decision signal and the target signal before the hard decision, and the coefficient value of the cancellation component is multiplied by the cancellation component, to obtain the intermediate signal.

A smaller error between the hard decision signal and the target signal before the hard decision indicates a smaller difference between the coefficient value of the cancellation component and an optimal value, and therefore indicates a better effect of canceling out the non-linear interference intermodulation product.

The addition circuit 6033 is further configured to obtain, based on the interference canceled signal and the intermediate signal, the target signal in which the non-linear intermodulation product is canceled out.

It should be noted that, as long as the signal processing apparatus is working, input signals may be continuously input to the signal processing apparatus. Therefore, when the signal processing apparatus starts to work, the first signal processing branch generates the interference canceled signal, the squaring circuit 6031 generates the squared signal, the canceling and solving circuit 6032 inputs the squared signal as the intermediate signal to the addition circuit 6033, and the addition circuit 6033 generates the target signal based on the intermediate signal and the interference canceled signal. However, in this case, an effect of canceling out an interference intermodulation product in the target signal is relatively poor. In this case, the addition circuit 6033 inputs the target signal to the hard decision circuit 6034 and the canceling and solving circuit 6032, so that the hard decision circuit 6034 performs error elimination on the target signal, to obtain the error eliminated signal, and inputs the error eliminated signal to the canceling and solving circuit 6032. The canceling and solving circuit 6032 then performs canceling and solving based on the received target signal, error eliminated signal, and squared signal, to obtain the intermediate signal used to cancel out the non-linear intermodulation product. The addition circuit 6033 may perform synthesis based on the intermediate signal and the received interference canceled signal, to obtain the target signal in which the non-linear intermodulation product is canceled out.

In an implementation, after the target signal in which the non-linear intermodulation product is canceled out is obtained, the addition circuit 6033 may further input the target signal in which the non-linear intermodulation product is canceled out to the hard decision circuit 6034 and the canceling and solving circuit 6032, to perform next signal processing. Through repeated iteration and convergence, an effect of filtering out the non-linear intermodulation product in the target signal can be increasingly better.

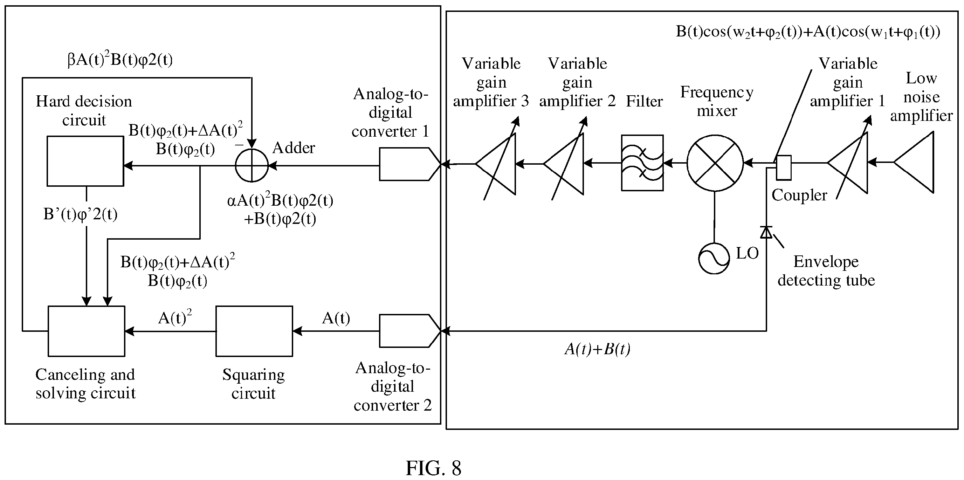

For clearer description, FIG. 8 is a schematic structural diagram of another signal processing apparatus according to this application. The signal processing apparatus shown in FIG. 8 may be a specific example of the foregoing signal processing apparatus. However, it should be learned that, in another feasible implementation, there may alternatively be another example of the signal processing apparatus, and this is not limited in this application.

The signal processing apparatus shown in FIG. 8 may include: a low noise amplifier, a variable gain amplifier 1, a frequency mixer, a variable gain amplifier 2, a variable gain amplifier 3, an analog-to-digital converter 1, an adder, a hard decision circuit, a canceling and solving circuit, a squaring circuit, an analog-to-digital converter 2, an envelope detecting tube, and a coupler.

After the low noise amplifier amplifies an input signal, the variable gain amplifier 1 may first perform power adjustment, to obtain a power adjusted signal, to ensure that power of a signal received by a next device is in a preset power range, and may match the next device. Specifically, the power adjusted signal may be represented as B(t)cos(w₂t+(ϕ₂(t))+A(t)cos(w₁t+ϕ₁(t)), where B(t)cos(w₂t+ϕ₂(t)) may represent a wanted signal, and A(t)cos(w₁t+ϕ₁(t)) may represent an interfering signal, and A(t) is far greater than B(t).

B(t) may represent amplitude information of the wanted signal, w₂t may represent carrier information of the wanted signal, and ϕ₂(t) may represent phase information of the wanted signal. Similarly, A(t) may represent amplitude information of the interfering signal, wit may represent carrier information of the interfering signal, and ϕ₁(t) may represent phase information of the interfering signal.

The power adjusted signal is input to the coupler, and is coupled by the coupler, to obtain two same signals, where the two same signals may also be represented as B(t)cos(w₂t+ϕ₂(t))+A(t)cos(w₁t+ϕ₁(t)). One of the two signals is input to the frequency mixer, and the other signal is input to the envelope detecting tube.

Frequency mixing processing may be performed on the signal input to the frequency mixer and an LO signal from a voltage-controlled oscillator, to obtain a mixed signal. The mixed signal is then input to a filter for filtering processing, to obtain a filtered signal. After the variable gain amplifier 2 and the variable gain amplifier 3 implement power adjustment on the filtered signal, to ensure that power of the filtered signal obtained after the power adjustment matches a next device, the filtered signal obtained after the power adjustment is input to the analog-to-digital converter 1, and is converted into an interference canceled signal in a digital domain. In this case, an expression of the interference canceled signal may be B(t)ϕ₂(t).

The envelope detecting tube may collect envelope information in the signal input to the envelope detecting tube, where the envelope information may be amplitude information of the signal, and may be represented as A(t)+B(t). Then the analog-to-digital converter 2 performs analog-to-digital conversion processing on the envelope information, to obtain a digital envelope signal. An expression of the digital envelope signal may also be A(t)+B(t). Because A(t) is far greater than B(t), the digital envelope signal may also be written as A(t). The digital envelope signal is input to the squaring circuit, and a modulus value of the digital envelope signal is squared, to obtain a squared signal, where an expression of the squared signal may be A(t)².

Before this processing, a target signal obtained by an addition circuit may be represented as B(t)ϕ₂(t)+ΔA(t)²B(t)ϕ₂(t), where A(t)²B(t)ϕ₂(t) may represent a non-linear intermodulation product, and Δ may represent a ratio coefficient of the non-linear intermodulation product. The addition circuit separately input the target signal to the hard decision circuit and the canceling and solving circuit. The hard decision circuit may perform error eliminating processing on the target signal based on a preset threshold, to obtain an error eliminated signal, where the error eliminated signal may be represented as B'(t)ϕ'₂(t).

The canceling and solving circuit may multiply the squared signal A(t)² by the error eliminated signal B'(t)ϕ'₂(t), to obtain a cancellation component, namely, A(t)²B(t)ϕ₂(t). The canceling and solving circuit may further solve a coefficient value β of the cancellation component based on an error ΔA(t)²B(t)ϕ₂(t) between the error eliminated signal B'(t)ϕ'₂(t) obtained after hard decision and the target signal B(t)ϕ₂(t)+ΔA(t)²B(t)ϕ₂(t) before the hard decision. The canceling and solving circuit multiplies the coefficient value β of the cancellation component by the cancellation component A(t)²B(t)ϕ₂(t), to obtain an intermediate signal βA(t)²B(t)ϕ₂(t), and inputs the intermediate signal to the adder. A smaller error between the target signal before the hard decision and the error eliminated signal after the hard decision indicates a smaller difference between the coefficient value β of the cancellation component and an optimal value α, and therefore indicates a better effect of canceling out the interference intermodulation product.

The adder may synthesize the intermediate signal βA(t)²B(t)ϕ₂(t) with the interference canceled signal B(t)ϕ₂(t), to obtain a target signal βA(t)²B(t)ϕ₂(t)+B(t)ϕ₂(t) in which the non-linear interference product is filtered out.

Further, the adder may input the target signal βA(t)²B(t)ϕ₂(t)+B(t)ϕ₂(t) to the hard decision circuit and the canceling and solving circuit again, to continuously optimize the coefficient value β through the canceling and solving circuit, so that the coefficient value β is closer to the optimal value α. In this way, a finally obtained target signal can be αA(t)²B(t)ϕ₂(t)+B(t)ϕ₂(t). In this case, the effect of filtering out the non-linear interference product is relatively good.

It can be learned that, in this implementation of this application, an envelope detecting circuit is integrated. The envelope detecting circuit collects envelope information of a second to-be-processed signal; the canceling and solving circuit generates the intermediate signal used to cancel out the non-linear intermodulation product; and an addition circuit synthesizes the intermediate signal with the interference canceled signal, to cancel out the non-linear intermodulation product in the digital domain, thereby obtaining the target signal, so that effective anti-interference processing can be performed on the non-linear intermodulation product, and signal quality is improved.

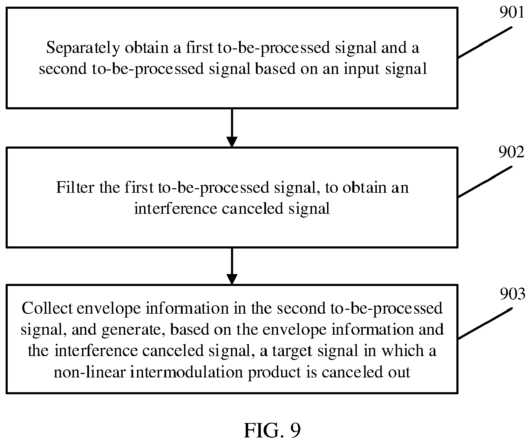

FIG. 9 is a schematic flowchart of a signal processing method according to this application. It should be noted that, the signal processing method may be applied to the foregoing signal processing apparatus. Specifically, the signal processing method shown in FIG. 9 may include the following steps.

901. Separately obtain a first to-be-processed signal and a second to-be-processed signal based on an input signal.

It should be noted that, a signal matching circuit in a signal processing apparatus may separately obtain the first to-be-processed signal and the second to-be-processed signal based on the input signal.

In an implementation, the separately obtaining a first to-be-processed signal and a second to-be-processed signal based on an input signal includes: amplifying the input signal, to obtain an amplified signal; performing power adjustment processing on the amplified signal, and adjusting a frequency of the amplified signal obtained after the power adjustment processing to a preset frequency range, to obtain a mixed signal; and coupling the mixed signal, to separately obtain the first to-be-processed signal and the second to-be-processed signal.

In an implementation, the separately obtaining a first to-be-processed signal and a second to-be-processed signal based on an input signal includes: amplifying the input signal, to obtain an amplified signal; coupling the amplified signal, to obtain the second to-be-processed signal; and performing power adjustment processing on the second to-be-processed signal, and adjusting a frequency of the second to-be-processed signal obtained after the power adjustment processing to a preset frequency range, to obtain the first to-be-processed signal.

In an implementation, the separately obtaining a first to-be-processed signal and a second to-be-processed signal based on an input signal includes: amplifying the input signal, to obtain an amplified signal; performing power adjustment processing on the amplified signal, and coupling the amplified signal obtained after the power adjustment processing, to obtain the second to-be-processed signal; and adjusting a frequency of the second to-be-processed signal to a preset frequency range, to obtain the first to-be-processed signal.

In an implementation, the separately obtaining a first to-be-processed signal and a second to-be-processed signal based on an input signal includes: coupling the input signal, to obtain the second to-be-processed signal; amplifying the second to-be-processed signal, to obtain an amplified signal; and performing power adjustment processing on the amplified signal, and adjusting a frequency of the amplified signal obtained after the power adjustment processing to a preset frequency range, to obtain the first to-be-processed signal.

902. Filter the first to-be-processed signal, to obtain an interference canceled signal.

It should be noted that, a first signal processing branch in the signal processing apparatus may filter the first to-be-processed signal, to obtain the interference canceled signal.

The interference canceled signal includes a non-linear intermodulation product.

In an implementation, the filtering the first to-be-processed signal, to obtain an interference canceled signal includes: filtering the first to-be-processed signal, to obtain a filtered signal; and performing power adjustment processing on the filtered signal, and performing analog-to-digital conversion processing on the filtered signal obtained after the power adjustment processing, to obtain the interference canceled signal.

903. Collect envelope information in the second to-be-processed signal, and generate, based on the envelope information and the interference canceled signal, a target signal in which the non-linear intermodulation product is canceled out.

It should be noted that, a second signal processing branch in the signal processing apparatus may collect the envelope information in the second to-be-processed signal, and generate, based on the envelope information and the interference canceled signal, the target signal in which the non-linear intermodulation product is canceled out.

In an implementation, the collecting envelope information in the second to-be-processed signal, and generating, based on the envelope information and the interference canceled signal, a target signal in which the non-linear intermodulation product is canceled out includes: collecting the envelope information in the second to-be-processed signal; performing first analog-to-digital conversion processing based on the envelope information, to obtain a digital envelope signal; and obtaining, based on the interference canceled signal and the digital envelope signal, the target signal in which the non-linear intermodulation product is canceled out.

In an implementation, the obtaining, based on the interference canceled signal and the digital envelope signal, the target signal in which the non-linear intermodulation product is canceled out includes: performing error eliminating processing on a target signal based on a preset threshold condition, to obtain an error eliminated signal; squaring the digital envelope signal, to obtain a squared signal; obtaining, based on the squared signal, the target signal, and the error eliminated signal, an intermediate signal used to cancel out the non-linear intermodulation product; and obtaining, based on the interference canceled signal and the intermediate signal, the target signal in which the non-linear intermodulation product is canceled out.

In an implementation, the obtaining, based on the squared signal, the target signal, and the error eliminated signal, an intermediate signal used to cancel out the non-linear intermodulation product includes: multiplying the squared signal by the error eliminated signal, to obtain a cancellation component used to cancel out the non-linear intermodulation product; performing error solving processing on the target signal and the error eliminated signal, to obtain a coefficient value of the cancellation component; and multiplying the coefficient value of the cancellation component by the cancellation component, to obtain the intermediate signal used to cancel out the non-linear intermodulation product.

It should be noted that, the signal processing method described in this application may be applied to the foregoing signal processing apparatus, and the descriptions of the processing procedure of the signal processing apparatus may also be applicable to the signal processing method. Details are not described herein again.

A person of ordinary skill in the art may understand that all or some of the steps of the methods in the implementations may be implemented by a program instructing related hardware. The program may be stored in a computer-readable storage medium. The storage medium may include a flash memory, a read-only memory (Read-Only Memory, ROM), a random access memory (Random Access Memory, RAM), a magnetic disk, an optical disk, or the like.

The scope of protection shall be defined by the appended claims.

## Claims

1. A signal processing apparatus, comprising: a signal matching circuit (301), a first signal processing branch (302), and a second signal processing branch (303), wherein
a first output end of the signal matching circuit is coupled to an input end of the first signal processing branch and a second output end of the signal matching circuit is coupled to a first input end of the second signal processing branch, and an output end of the first signal processing branch is coupled to a second input end of the second signal processing branch;
the signal matching circuit is configured to: separately obtain a first to-be-processed signal and a second to-be-processed signal based on an input signal including a wanted signal, an interfering signal, and a non-linear intermodulation product generated by the wanted signal and the interfering signal affecting each other,
input the first to-be-processed signal to the first signal processing branch, and input the second to-be-processed signal to the second signal processing branch;
the first signal processing branch is configured to filter the first to-be-processed signal, to obtain an interference canceled signal; and input the interference canceled signal to the second signal processing branch, wherein the interference canceled signal comprises the non-linear intermodulation product; and
the second signal processing branch is configured to collect envelope information in the second to-be-processed signal, and generate, based on the envelope information and the interference canceled signal, a target signal in which the non-linear intermodulation product is canceled out;
wherein the second signal processing branch comprises: an envelope detecting circuit (601), a first analog-to-digital conversion circuit (602), and a digital processing circuit (603), wherein
the second output end of the signal matching circuit is coupled to an input end of the envelope detecting circuit, an output end of the envelope detecting circuit is coupled to an input end of the first analog-to-digital conversion circuit, and an output end of the first analog-to-digital conversion circuit and the output end of the first signal processing branch are separately coupled to an input end of the digital processing circuit;
the envelope detecting circuit is configured to collect the envelope information in the second to-be-processed signal, and input the envelope information to the first analog-to-digital conversion circuit;
the first analog-to-digital conversion circuit is configured to perform first analog-to-digital conversion processing based on the envelope information, to obtain a digital envelope signal; and input the digital envelope signal to the digital processing circuit; and
the digital processing circuit is configured to obtain, based on the interference canceled signal and the digital envelope signal, the target signal in which the non-linear intermodulation product is canceled out;
wherein the digital processing circuit comprises: a squaring circuit (6031), a canceling and solving circuit (6032), an addition circuit (6033), and a hard decision circuit (6034); wherein
the output end of the first analog-to-digital conversion circuit is coupled to an input end of the squaring circuit; an output end of the squaring circuit, an output end of the hard decision circuit, and an output end of the addition circuit are separately coupled to an input end of the canceling and solving circuit; an output end of the canceling and solving circuit and the output end of the first signal processing branch are separately coupled to an input end of the addition circuit; and the output end of the addition circuit is coupled to an input end of the hard decision circuit;
the addition circuit is configured to separately input a target signal to the canceling and solving circuit and the hard decision circuit;
the hard decision circuit is configured to perform error eliminating processing on the target signal based on a preset threshold condition, to obtain an error eliminated signal; and input the error eliminated signal to the canceling and solving circuit;
the squaring circuit is configured to square a modulus value of the digital envelope signal, to obtain a squared signal; and input the squared signal to the canceling and solving circuit,
the canceling and solving circuit is configured to obtain, based on the squared signal, the target signal, and the error eliminated signal, an intermodulation product interference cancellation signal used to cancel out the non-linear intermodulation product, and input the intermodulation product interference cancellation signal to the addition circuit; and
the addition circuit is further configured to obtain, based on the interference canceled signal and the intermodulation product interference cancellation signal, the target signal in which the non-linear intermodulation product is canceled out;
wherein the input end of the envelope detecting circuit (601) forms the first input end of the second signal processing branch and the input end of the digital processing circuit (603) for the second input end of the second signal processing branch;
wherein the first signal processing branch comprises:
a filter circuit (501), a first power adjustment circuit (502), and a second analog-to-digital conversion circuit (503), wherein
an input end of the filter circuit is coupled to the output end of the signal matching circuit, an output end of the filter circuit is coupled to an input end of the first power adjustment circuit, an output end of the first power adjustment circuit is coupled to an input end of the second analog-to-digital conversion circuit, and an output end of the second analog-to-digital conversion circuit is coupled to the input end of the second signal processing branch;
wherein
the filter circuit is configured to filter the first to-be-processed signal, to obtain a filtered signal; and input the filtered signal to the first power adjustment circuit;
the first power adjustment circuit is configured to perform power adjustment processing on the filtered signal and then input the filtered signal obtained after the power adjustment processing to the second analog-to-digital conversion circuit; and
the second analog-to-digital conversion circuit is configured to perform analog-to-digital conversion processing on the filtered signal obtained after the power adjustment processing, to obtain the interference canceled signal; and input the interference canceled signal to the second signal processing branch;
wherein the input end of the filter circuit forms the input end of first signal processing branch and the output end of the second analog-to-digital conversion circuit forms the output end of first signal processing branch.

2. The apparatus according to claim 1, wherein the canceling and solving circuit is specifically configured to:
multiply the squared signal by the error eliminated signal, to obtain a cancellation component used to cancel out the non-linear intermodulation product;
perform error solving processing on the target signal and the error eliminated signal, to obtain a coefficient value of the cancellation component; and
multiply the coefficient value of the cancellation component by the cancellation component, to obtain the intermodulation product interference cancellation signal used to cancel out the non-linear intermodulation product; and input the intermodulation product interference cancellation signal to the addition circuit.

3. The apparatus according to claim 1, wherein the signal matching circuit comprises: a coupling circuit (401), a frequency mixing circuit (402), a second power adjustment circuit (403), and a signal amplification circuit (404), wherein
an output end of the signal amplification circuit is coupled to an input end of the second power adjustment circuit, an output end of the second power adjustment circuit is coupled to an input end of the frequency mixing circuit, an output end of the frequency mixing circuit is coupled to an input end of the coupling circuit, and an output end of the coupling circuit is separately coupled to the input end of the first signal processing branch and the input end of the second signal processing branch;
the signal amplification circuit is configured to amplify the input signal, to obtain an amplified signal; and input the amplified signal to the second power adjustment circuit;
the second power adjustment circuit is configured to perform power adjustment processing on the amplified signal and input the amplified signal obtained after the power adjustment processing to the frequency mixing circuit;
the frequency mixing circuit is configured to adjust a frequency of the amplified signal obtained after the power adjustment processing to a preset frequency range, to obtain a mixed signal; and input the mixed signal to the coupling circuit; and
the coupling circuit is configured to couple the mixed signal, to separately obtain the first to-be-processed signal and the second to-be-processed signal; input the first to-be-processed signal to the first signal processing branch; and input the second to-be-processed signal to the second signal processing branch.

4. The apparatus according to claim 1, wherein the signal matching circuit comprises: a frequency mixing circuit (405), a second power adjustment circuit (406), a coupling circuit (407), and a signal amplification circuit (408), wherein
an output end of the signal amplification circuit is coupled to an input end of the coupling circuit, an output end of the coupling circuit is separately coupled to the input end of the second signal processing branch and an input end of the second power adjustment circuit, an output end of the second power adjustment circuit is coupled to an input end of the frequency mixing circuit, and an output end of the frequency mixing circuit is coupled to the input end of the first signal processing branch;
the signal amplification circuit is configured to amplify the input signal, to obtain an amplified signal; and input the amplified signal to the coupling circuit;
the coupling circuit is configured to couple the amplified signal, to obtain the second to-be-processed signal; and separately input the second to-be-processed signal to the second power adjustment circuit and the second signal processing branch;
the second power adjustment circuit is configured to perform power adjustment processing on the second to-be-processed signal and input the second to-be-processed signal obtained after the power adjustment processing to the frequency mixing circuit; and
the frequency mixing circuit is configured to adjust a frequency of the second to-be-processed signal obtained after the power adjustment processing to a preset frequency range, to obtain the first to-be-processed signal; and input the first to-be-processed signal to the first signal processing branch.

5. The apparatus according to claim 1, wherein the signal matching circuit comprises: a frequency mixing circuit (409), a coupling circuit (410), a second power adjustment circuit (411), and a signal amplification circuit (412), wherein
an output end of the signal amplification circuit is coupled to an input end of the second power adjustment circuit, an output end of the second power adjustment circuit is coupled to an input end of the coupling circuit, an output end of the coupling circuit is separately coupled to an input end of the frequency mixing circuit and the input end of the second signal processing branch, and an output end of the frequency mixing circuit is coupled to the input end of the first signal processing branch;
the signal amplification circuit is configured to amplify the input signal, to obtain an amplified signal; and input the amplified signal to the second power adjustment circuit;
the second power adjustment circuit is configured to perform power adjustment processing on the amplified signal and input the amplified signal obtained after the power adjustment processing to the coupling circuit;
the coupling circuit is configured to couple the amplified signal obtained after the power adjustment processing, to obtain the second to-be-processed signal; and separately input the second to-be-processed signal to the frequency mixing circuit and the second signal processing branch; and
the frequency mixing circuit is configured to adjust a frequency of the second to-be-processed signal to a preset frequency range, to obtain the first to-be-processed signal; and input the first to-be-processed signal to the first signal processing branch.

6. The apparatus according to claim 1, wherein the signal matching circuit comprises: a frequency mixing circuit (413), a second power adjustment circuit (414), a signal amplification circuit (415), and a coupling circuit (416), wherein
an output end of the coupling circuit is separately coupled to the input end of the second signal processing branch and an input end of the signal amplification circuit, an output end of the signal amplification circuit is coupled to an input end of the second power adjustment circuit, an output end of the second power adjustment circuit is coupled to an input end of the frequency mixing circuit, and an output end of the frequency mixing circuit is coupled to the input end of the first signal processing branch;
the coupling circuit is configured to couple the input signal, to obtain the second to-be-processed signal; and separately input the second to-be-processed signal to the second signal processing branch and the signal amplification circuit;
the signal amplification circuit is configured to amplify the second to-be-processed signal, to obtain an amplified signal; and input the amplified signal to the second power adjustment circuit;
the second power adjustment circuit is configured to perform power adjustment processing on the amplified signal and input the amplified signal obtained after the power adjustment processing to the frequency mixing circuit; and
the frequency mixing circuit is configured to adjust a frequency of the amplified signal obtained after the power adjustment processing to a preset frequency range, to obtain the first to-be-processed signal; and input the first to-be-processed signal to the first signal processing branch.

7. A method for performing signal processing using a signal processing apparatus according to any one of claims 1 to 6, comprising:
separately obtaining (901), by the signal matching circuit, a first to-be-processed signal and a second to-be-processed signal based on an input signal including a wanted signal, an interfering signal, and a non-linear intermodulation product generated by the wanted signal and the interfering signal affecting each other, inputting, by the signal matching circuit, the first to-be-processed signal to the first signal processing branch, and inputting, , by the signal matching circuit, the second to-be-processed signal to the second signal processing branch;
filtering (902), by the first signal processing branch, the first to-be-processed signal to obtain an interference canceled signal; and inputting, by the first signal processing branch, the interference canceled signal to the second signal processing branch, wherein the interference canceled signal comprises the non-linear intermodulation product;
and
collecting (903), by the second signal processing branch, envelope information in the second to-be-processed signal, and generating, by the second signal processing branch, based on the envelope information and the interference canceled signal, a target signal in which the non-linear intermodulation product is canceled out;
wherein the method further comprises:
collecting, by the envelope detecting circuit, the envelope information in the second to-be-processed signal, and inputting, by the envelope detecting circuit, the envelope information to the first analog-to-digital conversion circuit;
performing, by the first analog-to-digital conversion circuit, first analog-to-digital conversion processing based on the envelope information to obtain a digital envelope signal; and inputting, by the first analog-to-digital conversion circuit, the digital envelope signal to the digital processing circuit; and
obtaining, by the digital processing circuit, based on the interference canceled signal and the digital envelope signal, the target signal in which the non-linear intermodulation product is canceled out;
wherein the method specifically comprises:
separately inputting, by the addition circuit, a target signal to the canceling and solving circuit and the hard decision circuit;
performing, by the hard decision circuit, error eliminating processing on the target signal based on a preset threshold condition to obtain an error eliminated signal; and inputting, by the hard decision circuit, the error eliminated signal to the canceling and solving circuit;
squaring, by the squaring circuit, a modulus value of the digital envelope signal, to obtain a squared signal; and inputting, by the squaring circuit, the squared signal to the canceling and solving circuit;
obtaining, by the canceling and solving circuit, based on the squared signal, the target signal, and the error eliminated signal, an intermodulation product interference cancellation signal used to cancel out the non-linear intermodulation product, and inputting, by the canceling and solving circuit, the intermodulation product interference cancellation signal to the addition circuit; and
obtaining, by the addition circuit, based on the interference canceled signal and the intermodulation product interference cancellation signal, the target signal in which the non-linear intermodulation product is canceled out;
wherein the filtering the first to-be-processed signal, to obtain an interference canceled signal comprises:
filtering the first to-be-processed signal, to obtain a filtered signal; and
performing power adjustment processing on the filtered signal, and performing analog-to-digital conversion processing on the filtered signal obtained after the power adjustment processing, to obtain the interference canceled signal.

8. The method according to claim 7, wherein the obtaining, based on the squared signal, the target signal, and the error eliminated signal, an intermodulation product interference cancellation signal used to cancel out the non-linear intermodulation product comprises:
multiplying the squared signal by the error eliminated signal, to obtain a cancellation component used to cancel out the non-linear intermodulation product;
performing error solving processing on the target signal and the error eliminated signal, to obtain a coefficient value of the cancellation component; and
multiplying the coefficient value of the cancellation component by the cancellation component, to obtain the intermodulation product interference cancellation signal used to cancel out the non-linear intermodulation product.

9. The method according to claim 7, wherein the separately obtaining a first to-be-processed signal and a second to-be-processed signal based on an input signal comprises:
amplifying the input signal, to obtain an amplified signal;
performing power adjustment processing on the amplified signal, and adjusting a frequency of the amplified signal obtained after the power adjustment processing to a preset frequency range, to obtain a mixed signal; and
coupling the mixed signal, to separately obtain the first to-be-processed signal and the second to-be-processed signal.

10. The method according to claim 7, wherein the separately obtaining a first to-be-processed signal and a second to-be-processed signal based on an input signal comprises:
amplifying the input signal, to obtain an amplified signal;
coupling the amplified signal, to obtain the second to-be-processed signal; and
performing power adjustment processing on the second to-be-processed signal, and adjusting a frequency of the second to-be-processed signal obtained after the power adjustment processing to a preset frequency range, to obtain the first to-be-processed signal.

11. The method according to claim 7, wherein the separately obtaining a first to-be-processed signal and a second to-be-processed signal based on an input signal comprises:
amplifying the input signal, to obtain an amplified signal;
performing power adjustment processing on the amplified signal, and coupling the amplified signal obtained after the power adjustment processing, to obtain the second to-be-processed signal; and
adjusting a frequency of the second to-be-processed signal to a preset frequency range, to obtain the first to-be-processed signal.

12. The method according to claim 7, wherein the separately obtaining a first to-be-processed signal and a second to-be-processed signal based on an input signal comprises:
coupling the input signal, to obtain the second to-be-processed signal;
amplifying the second to-be-processed signal, to obtain an amplified signal; and
performing power adjustment processing on the amplified signal, and adjusting a frequency of the amplified signal obtained after the power adjustment processing to a preset frequency range, to obtain the first to-be-processed signal.

## Patentansprüche

1. Signalverarbeitungseinrichtung, umfassend: eine Signalabgleichschaltung (301), einen ersten Signalverarbeitungszweig (302) und einen zweiten Signalverarbeitungszweig (303), wobei
ein erstes Ausgangsende der Signalabgleichschaltung mit einem Eingangsende des ersten Signalverarbeitungszweigs gekoppelt ist und ein zweites Ausgangsende der Signalabgleichschaltung mit einem ersten Eingangsende des zweiten Signalverarbeitungszweigs gekoppelt ist und ein Ausgangsende des ersten Signalverarbeitungszweigs mit einem zweiten Eingangsende des zweiten Signalverarbeitungszweigs gekoppelt ist;
die Signalabgleichschaltung zu Folgendem konfiguriert ist: separates Erlangen eines ersten zu verarbeitenden Signals und eines zweiten zu verarbeitenden Signals basierend auf einem Eingangssignal, das ein Nutzsignal, ein Störsignal und ein nichtlineares Intermodulationsprodukt beinhaltet, welches dadurch generiert wird, dass sich das Nutzsignal und das Störsignal gegenseitig beeinflussen, Eingeben des ersten zu verarbeitenden Signals in den ersten Signalverarbeitungszweig und Eingeben des zweiten zu verarbeitenden Signals in den zweiten Signalverarbeitungszweig;
der erste Signalverarbeitungszweig dazu konfiguriert ist, das erste zu verarbeitende Signal zu filtern, um ein störungsunterdrücktes Signal zu erlangen; und das störungsunterdrückte Signal in den zweiten Signalverarbeitungszweig einzugeben, wobei das störungsunterdrückte Signal das nichtlineare Intermodulationsprodukt umfasst; und
der zweite Signalverarbeitungszweig dazu konfiguriert ist, Hüllkurveninformationen in dem zweiten zu verarbeitenden Signal zu sammeln und basierend auf den Hüllkurveninformationen und dem störungsunterdrückten Signal ein Zielsignal zu generieren, in dem das nichtlineare Intermodulationsprodukt unterdrückt ist;
wobei der zweite Signalverarbeitungszweig Folgendes umfasst: eine Hüllkurvendetektionsschaltung (601), eine erste Analog-Digital-Umwandlungsschaltung (602) und eine digitale Verarbeitungsschaltung (603), wobei
das zweite Ausgangsende der Signalabgleichschaltung mit einem Eingangsende der Hüllkurvendetektionsschaltung gekoppelt ist, ein Ausgangsende der Hüllkurvendetektionsschaltung mit einem Eingangsende der ersten Analog-Digital-Umwandlungsschaltung gekoppelt ist und ein Ausgangsende der ersten Analog-Digital-Umwandlungsschaltung und das Ausgangsende des ersten Signalverarbeitungszweigs separat mit einem Eingangsende der digitalen Verarbeitungsschaltung gekoppelt sind;
die Hüllkurvendetektionsschaltung dazu konfiguriert ist, die Hüllkurveninformationen in dem zweiten zu verarbeitenden Signal zu sammeln und die Hüllkurveninformationen in die erste Analog-Digital-Umwandlungsschaltung einzugeben;
die erste Analog-Digital-Umwandlungsschaltung dazu konfiguriert ist, eine erste Analog-Digital-Umwandlungsverarbeitung basierend auf den Hüllkurveninformationen durchzuführen, um ein digitales Hüllkurvensignal zu erlangen; und das digitale Hüllkurvensignal in die digitale Verarbeitungsschaltung einzugeben; und
die digitale Verarbeitungsschaltung dazu konfiguriert ist, basierend auf dem störungsunterdrückten Signal und dem digitalen Hüllkurvensignal das Zielsignal zu erlangen, in dem das nichtlineare Intermodulationsprodukt unterdrückt ist;
wobei die digitale Verarbeitungsschaltung Folgendes umfasst: eine Quadrierschaltung (6031), eine Unterdrückungs- und Lösungsschaltung (6032), eine Additionsschaltung (6033) und eine Hard-Decision-Schaltung (6034); wobei
das Ausgangsende der ersten Analog-Digital-Umwandlungsschaltung mit einem Eingangsende der Quadrierschaltung gekoppelt ist; ein Ausgangsende der Quadrierschaltung, ein Ausgangsende der Hard-Decision-Schaltung und ein Ausgangsende der Additionsschaltung separat mit einem Eingangsende der Unterdrückungs- und Lösungsschaltung gekoppelt sind; ein Ausgangsende der Unterdrückungs- und Lösungsschaltung und das Ausgangsende des ersten Signalverarbeitungszweigs separat mit einem Eingangsende der Additionsschaltung gekoppelt sind; und das Ausgangsende der Additionsschaltung mit einem Eingangsende der Hard-Decision-Schaltung gekoppelt ist;
die Additionsschaltung dazu konfiguriert ist, ein Zielsignal separat in die Unterdrückungs- und Lösungsschaltung und die Hard-Decision-Schaltung einzugeben;
die Hard-Decision-Schaltung dazu konfiguriert ist, eine Fehlerbereinigungsverarbeitung an dem Zielsignal basierend auf einer zuvor festgelegten Schwellenwertbedingung durchzuführen, um ein fehlerbereinigtes Signal zu erlangen; und das fehlerbereinigte Signal in die Unterdrückungs- und Lösungsschaltung einzugeben;
die Quadrierschaltung dazu konfiguriert ist, einen Modulwert des digitalen Hüllkurvensignals zu quadrieren, um ein quadriertes Signal zu erlangen; und das quadrierte Signal in die Unterdrückungs- und Lösungsschaltung einzugeben,
die Unterdrückungs- und Lösungsschaltung dazu konfiguriert ist, basierend auf dem quadrierten Signal, dem Zielsignal und dem fehlerbereinigten Signal ein Störungsunterdrückungssignal des Intermodulationsprodukts zu erlangen, das zum Unterdrücken des nichtlinearen Intermodulationsprodukts verwendet wird, und das Störungsunterdrückungssignal des Intermodulationsprodukts in die Additionsschaltung einzugeben; und
die Additionsschaltung ferner dazu konfiguriert ist, basierend auf dem störungsunterdrückten Signal und dem Störungsunterdrückungssignal des Intermodulationsprodukts das Zielsignal zu erlangen, in dem das nichtlineare Intermodulationsprodukt unterdrückt ist;
wobei das Eingangsende der Hüllkurvendetektionsschaltung (601) das erste Eingangsende des zweiten Signalverarbeitungszweigs bildet und das Eingangsende der digitalen Verarbeitungsschaltung (603) das zweite Eingangsende des zweiten Signalverarbeitungszweigs bildet;
wobei der erste Signalverarbeitungszweig Folgendes umfasst: eine Filterschaltung (501), eine erste Leistungseinstellungsschaltung (502) und eine zweite Analog-Digital-Umwandlungsschaltung (503), wobei
ein Eingangsende der Filterschaltung mit dem Ausgangsende der Signalabgleichschaltung gekoppelt ist, ein Ausgangsende der Filterschaltung mit einem Eingangsende der ersten Leistungseinstellungsschaltung gekoppelt ist, ein Ausgangsende der ersten Leistungseinstellungsschaltung mit einem Eingangsende der zweiten Analog-Digital-Umwandlungsschaltung gekoppelt ist und ein Ausgangsende der zweiten Analog-Digital-Umwandlungsschaltung mit dem Eingangsende des zweiten Signalverarbeitungszweigs gekoppelt ist;
wobei
die Filterschaltung dazu konfiguriert ist, das erste zu verarbeitende Signal zu filtern, um ein gefiltertes Signal zu erlangen; und das gefilterte Signal in die erste Leistungseinstellungsschaltung einzugeben;
die erste Leistungseinstellungsschaltung dazu konfiguriert ist, eine Leistungseinstellungsverarbeitung an dem gefilterten Signal durchzuführen und dann das nach der Leistungseinstellungsverarbeitung erlangte gefilterte Signal in die zweite Analog-Digital-Umwandlungsschaltung einzugeben; und die zweite Analog-Digital-Umwandlungsschaltung dazu konfiguriert ist, eine Analog-Digital-Umwandlungsverarbeitung an dem nach der Leistungseinstellungsverarbeitung erlangten gefilterten Signal durchzuführen, um das störungsunterdrückte Signal zu erlangen; und das störungsunterdrückte Signal in den zweiten Signalverarbeitungszweig einzugeben;
wobei das Eingangsende der Filterschaltung das Eingangsende des ersten Signalverarbeitungszweigs bildet und das Ausgangsende der zweiten Analog-Digital-Umwandlungsschaltung das Ausgangsende des ersten Signalverarbeitungszweigs bildet.

2. Einrichtung nach Anspruch 1, wobei die Unterdrückungs- und Lösungsschaltung spezifisch zu Folgendem konfiguriert ist:
Multiplizieren des quadrierten Signals mit dem fehlerbereinigten Signal, um eine Unterdrückungskomponente zu erlangen, die zum Unterdrücken des nichtlinearen Intermodulationsprodukts verwendet wird;
Durchführen einer Fehlerlösungsverarbeitung an dem Zielsignal und dem fehlerbereinigten Signal, um einen Koeffizientenwert der Unterdrückungskomponente zu erlangen; und
Multiplizieren des Koeffizientenwerts der Unterdrückungskomponente mit der Unterdrückungskomponente, um das Störungsunterdrückungssignal des Intermodulationsprodukts zu erlangen, das zum Unterdrücken des nichtlinearen Intermodulationsprodukts verwendet wird; und Eingeben des Störungsunterdrückungssignals des Intermodulationsprodukts in die Additionsschaltung.

3. Einrichtung nach Anspruch 1, wobei die Signalabgleichschaltung Folgendes umfasst: eine Kopplungsschaltung (401), eine Frequenzmischschaltung (402), eine zweite Leistungseinstellungsschaltung (403) und eine Signalverstärkungsschaltung (404), wobei
ein Ausgangsende der Signalverstärkungsschaltung mit einem Eingangsende der zweiten Leistungseinstellungsschaltung gekoppelt ist, ein Ausgangsende der zweiten Leistungseinstellungsschaltung mit einem Eingangsende der Frequenzmischschaltung gekoppelt ist, ein Ausgangsende der Frequenzmischschaltung mit einem Eingangsende der Kopplungsschaltung gekoppelt ist und ein Ausgangsende der Kopplungsschaltung separat mit dem Eingangsende des ersten Signalverarbeitungszweigs und dem Eingangsende des zweiten Signalverarbeitungszweigs gekoppelt ist;
die Signalverstärkungsschaltung dazu konfiguriert ist, das Eingangssignal zu verstärken, um ein verstärktes Signal zu erlangen; und das verstärkte Signal in die zweite Leistungseinstellungsschaltung einzugeben;
die zweite Leistungseinstellungsschaltung dazu konfiguriert ist, eine Leistungseinstellungsverarbeitung an dem verstärkten Signal durchzuführen und das nach der Leistungseinstellungsverarbeitung erlangte verstärkte Signal in die Frequenzmischschaltung einzugeben;
die Frequenzmischschaltung dazu konfiguriert ist, eine Frequenz des nach der Leistungseinstellungsverarbeitung erlangten verstärkten Signals auf einen zuvor festgelegten Frequenzbereich einzustellen, um ein gemischtes Signal zu erlangen; und das gemischte Signal in die Kopplungsschaltung einzugeben; und
die Kopplungsschaltung dazu konfiguriert ist, das gemischte Signal zu koppeln, um das erste zu verarbeitende Signal und das zweite zu verarbeitende Signal separat zu erlangen; das erste zu verarbeitende Signal in den ersten Signalverarbeitungszweig einzugeben; und das zweite zu verarbeitende Signal in den zweiten Signalverarbeitungszweig einzugeben.

4. Einrichtung nach Anspruch 1, wobei die Signalabgleichschaltung Folgendes umfasst: eine Frequenzmischschaltung (405), eine zweite Leistungseinstellungsschaltung (406), eine Kopplungsschaltung (407) und eine Signalverstärkungsschaltung (408), wobei
ein Ausgangsende der Signalverstärkungsschaltung mit einem Eingangsende der Kopplungsschaltung gekoppelt ist, ein Ausgangsende der Kopplungsschaltung separat mit dem Eingangsende des zweiten Signalverarbeitungszweigs und einem Eingangsende der zweiten Leistungseinstellungsschaltung gekoppelt ist, ein Ausgangsende der zweiten Leistungseinstellungsschaltung mit einem Eingangsende der Frequenzmischschaltung gekoppelt ist und ein Ausgangsende der Frequenzmischschaltung mit dem Eingangsende des ersten Signalverarbeitungszweigs gekoppelt ist;
die Signalverstärkungsschaltung dazu konfiguriert ist, das Eingangssignal zu verstärken, um ein verstärktes Signal zu erlangen; und das verstärkte Signal in die Kopplungsschaltung einzugeben;
die Kopplungsschaltung dazu konfiguriert ist, das verstärkte Signal zu koppeln, um das zweite zu verarbeitende Signal zu erlangen; und das zweite zu verarbeitende Signal separat in die zweite Leistungseinstellungsschaltung und den zweiten Signalverarbeitungszweig einzugeben;
die zweite Leistungseinstellungsschaltung dazu konfiguriert ist, eine Leistungseinstellungsverarbeitung an dem zweiten zu verarbeitenden Signal durchzuführen und das nach der Leistungseinstellungsverarbeitung erlangte zweite zu verarbeitende Signal in die Frequenzmischschaltung einzugeben; und
die Frequenzmischschaltung dazu konfiguriert ist, eine Frequenz des nach der Leistungseinstellungsverarbeitung erlangten zweiten zu verarbeitenden Signals auf einen zuvor festgelegten Frequenzbereich einzustellen, um das erste zu verarbeitende Signal zu erlangen; und das erste zu verarbeitende Signal in den ersten Signalverarbeitungszweig einzugeben.

5. Einrichtung nach Anspruch 1, wobei die Signalabgleichschaltung Folgendes umfasst: eine Frequenzmischschaltung (409), eine Kopplungsschaltung (410), eine zweite Leistungseinstellungsschaltung (411) und eine Signalverstärkungsschaltung (412), wobei
ein Ausgangsende der Signalverstärkungsschaltung mit einem Eingangsende der zweiten Leistungseinstellungsschaltung gekoppelt ist, ein Ausgangsende der zweiten Leistungseinstellungsschaltung mit einem Eingangsende der Kopplungsschaltung gekoppelt ist, ein Ausgangsende der Kopplungsschaltung separat mit einem Eingangsende der Frequenzmischschaltung und dem Eingangsende des zweiten Signalverarbeitungszweigs gekoppelt ist und ein Ausgangsende der Frequenzmischschaltung mit dem Eingangsende des ersten Signalverarbeitungszweigs gekoppelt ist;
die Signalverstärkungsschaltung dazu konfiguriert ist, das Eingangssignal zu verstärken, um ein verstärktes Signal zu erlangen; und das verstärkte Signal in die zweite Leistungseinstellungsschaltung einzugeben;
die zweite Leistungseinstellungsschaltung dazu konfiguriert ist, eine Leistungseinstellungsverarbeitung an dem verstärkten Signal durchzuführen und das nach der Leistungseinstellungsverarbeitung erlangte verstärkte Signal in die Kopplungsschaltung einzugeben;
die Kopplungsschaltung dazu konfiguriert ist, das nach der Leistungseinstellungsverarbeitung erlangte verstärkte Signal zu koppeln, um das zweite zu verarbeitende Signal zu erlangen; und
das zweite zu verarbeitende Signal separat in die Frequenzmischschaltung und den zweiten Signalverarbeitungszweig einzugeben; und
die Frequenzmischschaltung dazu konfiguriert ist, eine Frequenz des zweiten zu verarbeitenden Signals auf einen zuvor festgelegten Frequenzbereich einzustellen, um das erste zu verarbeitende Signal zu erlangen; und das erste zu verarbeitende Signal in den ersten Signalverarbeitungszweig einzugeben.

6. Einrichtung nach Anspruch 1, wobei die Signalabgleichschaltung Folgendes umfasst: eine Frequenzmischschaltung (413), eine zweite Leistungseinstellungsschaltung (414), eine Signalverstärkungsschaltung (415) und eine Kopplungsschaltung (416), wobei
ein Ausgangsende der Kopplungsschaltung separat mit dem Eingangsende des zweiten Signalverarbeitungszweigs und einem Eingangsende der Signalverstärkungsschaltung gekoppelt ist, ein Ausgangsende der Signalverstärkungsschaltung mit einem Eingangsende der zweiten Leistungseinstellungsschaltung gekoppelt ist, ein Ausgangsende der zweiten Leistungseinstellungsschaltung mit einem Eingangsende der Frequenzmischschaltung gekoppelt ist und ein Ausgangsende der Frequenzmischschaltung mit dem Eingangsende des ersten Signalverarbeitungszweigs gekoppelt ist;
die Kopplungsschaltung dazu konfiguriert ist, das Eingangssignal zu koppeln, um das zweite zu verarbeitende Signal zu erlangen; und das zweite zu verarbeitende Signal separat in den zweiten Signalverarbeitungszweig und die Signalverstärkungsschaltung einzugeben;
die Signalverstärkungsschaltung dazu konfiguriert ist, das zweite zu verarbeitende Signal zu verstärken, um ein verstärktes Signal zu erlangen; und das verstärkte Signal in die zweite Leistungseinstellungsschaltung einzugeben;
die zweite Leistungseinstellungsschaltung dazu konfiguriert ist, eine Leistungseinstellungsverarbeitung an dem verstärkten Signal durchzuführen und das nach der Leistungseinstellungsverarbeitung erlangte verstärkte Signal in die Frequenzmischschaltung einzugeben; und
die Frequenzmischschaltung dazu konfiguriert ist, eine Frequenz des nach der Leistungseinstellungsverarbeitung erlangten verstärkten Signals auf einen zuvor festgelegten Frequenzbereich einzustellen, um das erste zu verarbeitende Signal zu erlangen; und das erste zu verarbeitende Signal in den ersten Signalverarbeitungszweig einzugeben.

7. Verfahren zum Durchführen einer Signalverarbeitung unter Verwendung einer Signalverarbeitungseinrichtung nach einem der Ansprüche 1 bis 6, umfassend:
separates Erlangen (901), durch die Signalabgleichschaltung, eines ersten zu verarbeitenden Signals und eines zweiten zu verarbeitenden Signals basierend auf einem Eingangssignal, das ein Nutzsignal, ein Störsignal und ein nichtlineares Intermodulationsprodukt beinhaltet, welches dadurch generiert wird, dass sich das Nutzsignal und das Störsignal gegenseitig beeinflussen,
Eingeben, durch die Signalabgleichschaltung, des ersten zu verarbeitenden Signals in den ersten Signalverarbeitungszweig und Eingeben, durch die Signalabgleichschaltung, des zweiten zu verarbeitenden Signals in den zweiten Signalverarbeitungszweig; Filtern (902), durch den ersten Signalverarbeitungszweig, des ersten zu verarbeitenden Signals, um ein störungsunterdrücktes Signal zu erlangen; und Eingeben, durch den ersten Signalverarbeitungszweig, des störungsunterdrückten Signals in den zweiten Signalverarbeitungszweig, wobei das störungsunterdrückte Signal das nichtlineare Intermodulationsprodukt umfasst; und
Sammeln (903), durch den zweiten Signalverarbeitungszweig, von Hüllkurveninformationen in dem zweiten zu verarbeitenden Signal und Generieren, durch den zweiten Signalverarbeitungszweig, basierend auf den Hüllkurveninformationen und dem störungsunterdrückten Signal, eines Zielsignals, in dem das nichtlineare Intermodulationsprodukt unterdrückt ist;
wobei das Verfahren ferner Folgendes umfasst:
Sammeln, durch die Hüllkurvendetektionsschaltung, der Hüllkurveninformationen in dem zweiten zu verarbeitenden Signal und Eingeben, durch die Hüllkurvendetektionsschaltung, der Hüllkurveninformationen in die erste Analog-Digital-Umwandlungsschaltung;
Durchführen, durch die erste Analog-Digital-Umwandlungsschaltung, einer ersten Analog-Digital-Umwandlungsverarbeitung basierend auf den Hüllkurveninformationen, um ein digitales Hüllkurvensignal zu erlangen; und Eingeben, durch die Analog-Digital-Umwandlungsschaltung, des digitalen Hüllkurvensignals in die digitale Verarbeitungsschaltung; und
Erlangen, durch die digitale Verarbeitungsschaltung, basierend auf dem störungsunterdrückten Signal und dem digitalen Hüllkurvensignal, des Zielsignals, in dem das nichtlineare Intermodulationsprodukt unterdrückt ist;
wobei das Verfahren spezifisch Folgendes umfasst:
separates Eingeben, durch die Additionsschaltung, eines Zielsignals in die Unterdrückungs- und Lösungsschaltung und die Hard-Decision-Schaltung;
Durchführen, durch die Hard-Decision-Schaltung, einer Fehlerbereinigungsverarbeitung an dem Zielsignal basierend auf einer zuvor festgelegten Schwellenwertbedingung, um ein fehlerbereinigtes Signal zu erlangen; und Eingeben, durch die Hard-Decision-Schaltung, des fehlerbereinigten Signals in die Unterdrückungs- und Lösungsschaltung;
Quadrieren, durch die Quadrierschaltung, eines Modulwerts des digitalen Hüllkurvensignals, um ein quadriertes Signal zu erlangen; und Eingeben, durch die Quadrierschaltung, des quadrierten Signals in die Unterdrückungs- und Lösungsschaltung; Erlangen, durch die Unterdrückungs- und Lösungsschaltung, basierend auf dem quadrierten Signal, dem Zielsignal und dem fehlerbereinigten Signal, eines Störungsunterdrückungssignals des Intermodulationsprodukts, das zum Unterdrücken des nichtlinearen Intermodulationsprodukts verwendet wird, und Eingeben, durch die Unterdrückungs- und Lösungsschaltung, des Störungsunterdrückungssignals des Intermodulationsprodukts in die Additionsschaltung; und
Erlangen, durch die Additionsschaltung, basierend auf dem störungsunterdrückten Signal und dem Störungsunterdrückungssignal des Intermodulationsprodukts, des Zielsignals, in dem das nichtlineare Intermodulationsprodukt unterdrückt ist;
wobei das Filtern des ersten zu verarbeitenden Signals, um ein störungsunterdrücktes Signal zu erlangen, Folgendes umfasst:
Filtern des ersten zu verarbeitenden Signals, um ein gefiltertes Signal zu erlangen; und
Durchführen einer Leistungseinstellungsverarbeitung an dem gefilterten Signal und Durchführen einer Analog-Digital-Umwandlungsverarbeitung an dem nach der Leistungseinstellungsverarbeitung erlangten gefilterten Signal, um das störungsunterdrückte Signal zu erlangen.

8. Verfahren nach Anspruch 7, wobei das Erlangen, basierend auf dem quadrierten Signal, dem Zielsignal und dem fehlerbereinigten Signal, eines Störungsunterdrückungssignals des Intermodulationsprodukts, das zum Unterdrücken des nichtlinearen Intermodulationsprodukts verwendet wird, Folgendes umfasst:
Multiplizieren des quadrierten Signals mit dem fehlerbereinigten Signal, um eine Unterdrückungskomponente zu erlangen, die zum Unterdrücken des nichtlinearen Intermodulationsprodukts verwendet wird;
Durchführen einer Fehlerlösungsverarbeitung an dem Zielsignal und dem fehlerbereinigten Signal, um einen Koeffizientenwert der Unterdrückungskomponente zu erlangen; und
Multiplizieren des Koeffizientenwerts der Unterdrückungskomponente mit der Unterdrückungskomponente, um das Störungsunterdrückungssignal des Intermodulationsprodukts zu erlangen, das zum Unterdrücken des nichtlinearen Intermodulationsprodukts verwendet wird.

9. Verfahren nach Anspruch 7, wobei das separate Erlangen eines ersten zu verarbeitenden Signals und eines zweiten zu verarbeitenden Signals basierend auf einem Eingangssignal Folgendes umfasst:
Verstärken des Eingangssignals, um ein verstärktes Signal zu erlangen;
Durchführen einer Leistungseinstellungsverarbeitung an dem verstärkten Signal und Einstellen einer Frequenz des nach der Leistungseinstellungsverarbeitung erlangten verstärkten Signals auf einen zuvor festgelegten Frequenzbereich, um ein gemischtes Signal zu erlangen; und
Koppeln des gemischten Signals, um separat das erste zu verarbeitende Signal und das zweite zu verarbeitende Signal zu erlangen.

10. Verfahren nach Anspruch 7, wobei das separate Erlangen eines ersten zu verarbeitenden Signals und eines zweiten zu verarbeitenden Signals basierend auf einem Eingangssignal Folgendes umfasst:
Verstärken des Eingangssignals, um ein verstärktes Signal zu erlangen;
Koppeln des verstärkten Signals, um das zweite zu verarbeitende Signal zu erlangen; und
Durchführen einer Leistungseinstellungsverarbeitung an dem zweiten zu verarbeitenden Signal und Einstellen einer Frequenz des nach der Leistungseinstellungsverarbeitung erlangten zweiten zu verarbeitenden Signals auf einen zuvor festgelegten Frequenzbereich, um das erste zu verarbeitende Signal zu erlangen.

11. Verfahren nach Anspruch 7, wobei das separate Erlangen eines ersten zu verarbeitenden Signals und eines zweiten zu verarbeitenden Signals basierend auf einem Eingangssignal Folgendes umfasst:
Verstärken des Eingangssignals, um ein verstärktes Signal zu erlangen;
Durchführen einer Leistungseinstellungsverarbeitung an dem verstärkten Signal und Koppeln des nach der Leistungseinstellungsverarbeitung erlangten verstärkten Signals, um das zweite zu verarbeitende Signal zu erlangen; und
Einstellen einer Frequenz des zweiten zu verarbeitenden Signals auf einen zuvor festgelegten Frequenzbereich, um das erste zu verarbeitende Signal zu erlangen.

12. Verfahren nach Anspruch 7, wobei das separate Erlangen eines ersten zu verarbeitenden Signals und eines zweiten zu verarbeitenden Signals basierend auf einem Eingangssignal Folgendes umfasst:
Koppeln des Eingangssignals, um das zweite zu verarbeitende Signal zu erlangen;
Verstärken des zweiten zu verarbeitenden Signals, um ein verstärktes Signal zu erlangen; und
Durchführen einer Leistungseinstellungsverarbeitung an dem verstärkten Signal und Einstellen einer Frequenz des nach der Leistungseinstellungsverarbeitung erlangten verstärkten Signals auf einen zuvor festgelegten Frequenzbereich, um das erste zu verarbeitende Signal zu erlangen.

## Revendications

1. Appareil de traitement de signal, comprenant : un circuit d'adaptation de signal (301), une première branche de traitement de signal (302) et une seconde branche de traitement de signal (303), dans lequel
une première extrémité de sortie du circuit d'adaptation de signal est couplée à une extrémité d'entrée de la première branche de traitement de signal et une seconde extrémité de sortie du circuit d'adaptation de signal est couplée à une première extrémité d'entrée de la seconde branche de traitement de signal, et une extrémité de sortie de la première branche de traitement de signal est couplée à une seconde extrémité d'entrée de la seconde branche de traitement de signal ;
le circuit d'adaptation de signal est configuré pour : obtenir séparément un premier signal à traiter et un second signal à traiter sur la base d'un signal d'entrée comportant un signal utile, un signal brouilleur et un produit d'intermodulation non linéaire généré par le signal utile et le signal brouilleur s'influençant mutuellement, entrer le premier signal à traiter dans la première branche de traitement de signal, et entrer le second signal à traiter dans la seconde branche de traitement de signal ;
la première branche de traitement de signal est configurée pour filtrer le premier signal à traiter, afin d'obtenir un signal annulé d'interférence ; et entrer le signal annulé d'interférence dans la seconde branche de traitement de signal, dans lequel le signal annulé d'interférence comprend le produit d'intermodulation non linéaire ; et
la seconde branche de traitement de signal est configurée pour collecter des informations d'enveloppe dans le second signal à traiter et générer, sur la base des informations d'enveloppe et du signal annulé d'interférence, un signal cible dans lequel le produit d'intermodulation non linéaire est annulé ;
dans lequel la seconde branche de traitement de signal comprend : un circuit de détection d'enveloppe (601), un premier circuit de conversion analogique-numérique (602) et un circuit de traitement numérique (603), dans lequel
la seconde extrémité de sortie du circuit d'adaptation de signal est couplée à une extrémité d'entrée du circuit de détection d'enveloppe, une extrémité de sortie du circuit de détection d'enveloppe est couplée à une extrémité d'entrée du premier circuit de conversion analogique-numérique, et une extrémité de sortie du premier circuit de conversion analogique-numérique et l'extrémité de sortie de la première branche de traitement de signal sont couplées séparément à une extrémité d'entrée du circuit de traitement numérique ;
le circuit de détection d'enveloppe est configuré pour collecter les informations d'enveloppe dans le second signal à traiter, et entrer les informations d'enveloppe dans le premier circuit de conversion analogique-numérique ;
le premier circuit de conversion analogique-numérique est configuré pour effectuer un premier traitement de conversion analogique-numérique sur la base des informations d'enveloppe, afin d'obtenir un signal d'enveloppe numérique ; et entrer le signal d'enveloppe numérique dans le circuit de traitement numérique ; et
le circuit de traitement numérique est configuré pour obtenir, sur la base du signal annulé d'interférence et du signal d'enveloppe numérique, le signal cible dans lequel le produit d'intermodulation non linéaire est annulé ;
dans lequel le circuit de traitement numérique comprend : un circuit de mise au carré (6031), un circuit d'annulation et de résolution (6032), un circuit d'addition (6033) et un circuit de décision ferme (6034) ; dans lequel
l'extrémité de sortie du premier circuit de conversion analogique-numérique est couplée à une extrémité d'entrée du circuit de mise au carré ; une extrémité de sortie du circuit de mise au carré, une extrémité de sortie du circuit de décision ferme et une extrémité de sortie du circuit d'addition sont couplées séparément à une extrémité d'entrée du circuit d'annulation et de résolution ; une extrémité de sortie du circuit d'annulation et de résolution et l'extrémité de sortie de la première branche de traitement de signal sont couplées séparément à une extrémité d'entrée du circuit d'addition ; et l'extrémité de sortie du circuit d'addition est couplée à une extrémité d'entrée du circuit de décision ferme ;
le circuit d'addition est configuré pour entrer séparément un signal cible dans le circuit d'annulation et de résolution et dans le circuit de décision ferme ;
le circuit de décision ferme est configuré pour effectuer un traitement d'élimination d'erreur sur le signal cible sur la base d'une condition de seuil prédéfinie, afin d'obtenir un signal d'erreur éliminée ; et entrer le signal d'erreur éliminée dans le circuit d'annulation et de résolution ;
le circuit de mise au carré est configuré pour mettre au carré une valeur de module du signal d'enveloppe numérique, afin d'obtenir un signal au carré ; et entrer le signal au carré dans le circuit d'annulation et de résolution,
le circuit d'annulation et de résolution est configuré pour obtenir, sur la base du signal au carré, du signal cible et du signal d'erreur éliminée, un signal d'annulation d'interférence de produit d'intermodulation utilisé pour annuler le produit d'intermodulation non linéaire, et entrer l'annulation d'interférence de produit d'intermodulation signal dans le circuit d'addition ; et
le circuit d'addition est en outre configuré pour obtenir, sur la base du signal d'annulation d'interférence et du signal d'annulation d'interférence de produit d'intermodulation, le signal cible dans lequel le produit d'intermodulation non linéaire est annulé ;
dans lequel l'extrémité d'entrée du circuit de détection d'enveloppe (601) forme la première extrémité d'entrée de la seconde branche de traitement de signal et l'extrémité d'entrée du circuit de traitement numérique (603) pour la seconde extrémité d'entrée de la seconde branche de traitement de signal ;
dans lequel la première branche de traitement de signal comprend :
un circuit filtrant (501), un premier circuit de réglage de puissance (502) et un second circuit de conversion analogique-numérique (503), dans lequel
une extrémité d'entrée du circuit filtrant est couplée à l'extrémité de sortie du circuit d'adaptation de signal, une extrémité de sortie du circuit filtrant est couplée à une extrémité d'entrée du premier circuit de réglage de puissance, une extrémité de sortie du premier circuit de réglage de puissance est couplée à une extrémité d'entrée du second circuit de conversion analogique-numérique, et une extrémité de sortie du second circuit de conversion analogique-numérique est couplée à l'extrémité d'entrée de la seconde branche de traitement de signal ;
dans lequel
le circuit filtrant est configuré pour filtrer le premier signal à traiter, afin d'obtenir un signal filtré ; et entrer le signal filtré dans le premier circuit de réglage de puissance ;
le premier circuit de réglage de puissance est configuré pour effectuer un traitement de réglage de puissance sur le signal filtré, puis entrer le signal filtré obtenu après le traitement de réglage de puissance dans le second circuit de conversion analogique-numérique ; et
le second circuit de conversion analogique-numérique est configuré pour effectuer un traitement de conversion analogique-numérique sur le signal filtré obtenu après le traitement d'ajustement de puissance, afin d'obtenir le signal annulé d'interférence ; et entrer le signal annulé d'interférence dans la seconde branche de traitement de signal ;
dans lequel l'extrémité d'entrée du circuit filtrant forme l'extrémité d'entrée de la première branche de traitement de signal et l'extrémité de sortie du second circuit de conversion analogique-numérique forme l'extrémité de sortie de la première branche de traitement de signal.

2. Appareil selon la revendication 1, dans lequel circuit d'annulation et de résolution est spécifiquement configuré pour :
multiplier le signal au carré par le signal d'erreur éliminée, pour obtenir une composante d'annulation utilisée pour annuler le produit d'intermodulation non linéaire ;
effectuer un traitement de résolution d'erreur sur le signal cible et le signal d'erreur éliminée, pour obtenir une valeur de coefficient de la composante d'annulation ; et
multiplier la valeur du coefficient de la composante d'annulation par la composante d'annulation, pour obtenir le signal d'annulation d'interférence du produit d'intermodulation utilisé pour annuler le produit d'intermodulation non linéaire ;
et entrer le signal d'annulation d'interférence du produit d'intermodulation dans le circuit d'addition.

3. Appareil selon la revendication 1, dans lequel le circuit d'adaptation de signal comprend : un circuit de couplage (401), un circuit de mélange de fréquence (402), un second circuit de réglage de puissance (403) et un circuit d'amplification de signal (404), dans lequel
une extrémité de sortie du circuit d'amplification de signal est couplée à une extrémité d'entrée du second circuit de réglage de puissance, une extrémité de sortie du second circuit de réglage de puissance est couplée à une extrémité d'entrée du circuit de mélange de fréquence, une extrémité de sortie du circuit de mélange de fréquence est couplée à une extrémité d'entrée du circuit de couplage, et une extrémité de sortie du circuit de couplage est couplée séparément à l'extrémité d'entrée de la première branche de traitement de signal et à l'extrémité d'entrée de la seconde branche de traitement de signal ;
le circuit d'amplification de signal est configuré pour amplifier le signal d'entrée, afin d'obtenir un signal amplifié ; et entrer le signal amplifié dans le second circuit de réglage de puissance ;
le second circuit de réglage de puissance est configuré pour effectuer un traitement de réglage de puissance sur le signal amplifié et entrer le signal amplifié obtenu après le traitement de réglage de puissance dans le circuit de mélange de fréquence ; le circuit de mélange de fréquence est configuré pour ajuster une fréquence du signal amplifié obtenu après le traitement de réglage de puissance à une plage de fréquences prédéfinie, afin d'obtenir un signal mixte ; et entrer le signal mixte dans le circuit de couplage ; et
le circuit de couplage est configuré pour coupler le signal mixte, afin d'obtenir séparément le premier signal à traiter et le second signal à traiter ; entrer le premier signal à traiter dans la première branche de traitement de signal ; et entrer le second signal à traiter dans la seconde branche de traitement de signal.

4. Appareil selon la revendication 1, dans lequel le circuit d'adaptation de signal comprend : un circuit de mélange de fréquence (405), un second circuit de réglage de puissance (406), un circuit de couplage (407) et un circuit d'amplification de signal (408), dans lequel
une extrémité de sortie du circuit d'amplification de signal est couplée à une extrémité d'entrée du circuit de couplage, une extrémité de sortie du circuit de couplage est couplée séparément à l'extrémité d'entrée de la seconde branche de traitement de signal et d'une extrémité d'entrée du second circuit de réglage de puissance, une extrémité de sortie du second circuit de réglage de puissance est couplée à une extrémité d'entrée du circuit de mélange de fréquence, et une extrémité de sortie du circuit de mélange de fréquence est couplée à l'extrémité d'entrée de la première branche de traitement de signal ;
le circuit d'amplification de signal est configuré pour amplifier le signal d'entrée, afin d'obtenir un signal amplifié ; et entrer le signal amplifié dans le circuit de couplage ;
le circuit de couplage est configuré pour coupler le signal amplifié, afin d'obtenir le second signal à traiter ; et entrer séparément le second signal à traiter dans le second circuit de réglage de puissance et la seconde branche de traitement de signal ;
le second circuit de réglage de puissance est configuré pour effectuer un traitement de réglage de puissance sur le second signal à traiter et entrer le second signal à traiter obtenu après le traitement de réglage de puissance dans le circuit de mélange de fréquence ; et
le circuit de mélange de fréquence est configuré pour ajuster une fréquence du second signal à traiter obtenu après le traitement de réglage de puissance à une plage de fréquences prédéfinie, afin d'obtenir le premier signal à traiter ; et entrer le premier signal à traiter dans la première branche de traitement de signal.

5. Appareil selon la revendication 1, dans lequel le circuit d'adaptation de signal comprend : un circuit de mélange de fréquence (409), un circuit de couplage (410), un second circuit de réglage de puissance (411) et un circuit d'amplification de signal (412), dans lequel
une extrémité de sortie du circuit d'amplification de signal est couplée à une extrémité d'entrée du second circuit de réglage de puissance, une extrémité de sortie du second circuit de réglage de puissance est couplée à une extrémité d'entrée du circuit de couplage, une extrémité de sortie du circuit de couplage est couplée séparément à une extrémité d'entrée du circuit de mélange de fréquence et l'extrémité d'entrée de la seconde branche de traitement de signal, et une extrémité de sortie du circuit de mélange de fréquence est couplée à l'extrémité d'entrée de la première branche de traitement de signal ;
le circuit d'amplification de signal est configuré pour amplifier le signal d'entrée, afin d'obtenir un signal amplifié ; et entrer le signal amplifié dans le second circuit de réglage de puissance ;
le second circuit de réglage de puissance est configuré pour effectuer un traitement de réglage de puissance sur le signal amplifié et entrer le signal amplifié obtenu après le traitement de réglage de puissance dans le circuit de couplage ;
le circuit de couplage est configuré pour coupler le signal amplifié obtenu après le traitement de réglage de puissance, afin d'obtenir le second signal à traiter ; et entrer séparément le second signal à traiter dans le circuit de mélange de fréquence et la seconde branche de traitement de signal ; et
le circuit de mélange de fréquence est configuré pour ajuster une fréquence du second signal à traiter obtenu à une plage de fréquences prédéfinie, afin d'obtenir le premier signal à traiter ; et entrer le premier signal à traiter dans la première branche de traitement de signal.

6. Appareil selon la revendication 1, dans lequel le circuit d'adaptation de signal comprend : un circuit de mélange de fréquence (413), un second circuit de réglage de puissance (414), un circuit d'amplification de signal (415) et un circuit de couplage (416), dans lequel
une extrémité de sortie du circuit de couplage est couplée séparément à l'extrémité d'entrée de la seconde branche de traitement de signal et à une extrémité d'entrée du circuit d'amplification de signal, une extrémité de sortie du circuit d'amplification de signal est couplée à une extrémité d'entrée du second circuit de réglage de puissance, une extrémité de sortie du second circuit de réglage de puissance est couplée à une extrémité d'entrée du circuit de mélange de fréquence, et une extrémité de sortie du circuit de mélange de fréquence est couplée à l'extrémité d'entrée de la première branche de traitement de signal ;
le circuit de couplage est configuré pour coupler le signal d'entrée, afin d'obtenir le second signal à traiter ; et entrer séparément le second signal à traiter dans la seconde branche de traitement de signal et dans le circuit d'amplification de signal ;
le circuit d'amplification de signal est configuré pour amplifier le second signal à traiter, afin d'obtenir un signal amplifié ; et entrer le signal amplifié dans le second circuit de réglage de puissance ;
le second circuit de réglage de puissance est configuré pour effectuer un traitement de réglage de puissance sur le signal amplifié et entrer le signal amplifié obtenu après le traitement de réglage de puissance dans le circuit de mélange de fréquence ; et
le circuit de mélange de fréquence est configuré pour ajuster une fréquence du signal amplifié obtenu après le traitement de réglage de puissance à une plage de fréquences prédéfinie, afin d'obtenir le premier signal à traiter ; et entrer le premier signal à traiter dans la première branche de traitement de signal.

7. Procédé pour effectuer un traitement de signal à l'aide d'un appareil de traitement de signal selon l'une quelconque des revendications 1 à 6, comprenant :
l'obtention séparée (901), par le circuit d'adaptation de signal, d'un premier signal à traiter et un second signal à traiter sur la base d'un signal d'entrée comportant un signal utile, un signal brouilleur et un produit d'intermodulation non linéaire généré par le signal utile et le signal brouilleur s'influençant mutuellement,
le fait d'entrer, par le circuit d'adaptation de signal, le premier signal à traiter dans la première branche de traitement de signal, et le fait d'entrer, par le circuit d'adaptation de signal, le second signal à traiter dans la seconde branche de traitement de signal ;
le filtrage (902), par la première branche de traitement de signal, du premier signal à traiter, afin d'obtenir un signal annulé d'interférence ; et le fait d'entrer, par la première branche de traitement de signal, le signal annulé d'interférence dans la seconde branche de traitement de signal, dans lequel le signal annulé d'interférence comprend le produit d'intermodulation non linéaire ; et
la collecte (903), par la seconde branche de traitement de signal, d'informations d'enveloppe dans le second signal à traiter et la génération, par la seconde branche de traitement de signal, sur la base des informations d'enveloppe et du signal annulé d'interférence, d'un signal cible dans lequel le produit d'intermodulation non linéaire est annulé ;
dans lequel le procédé comprend en outre :
la collecte, par le circuit de détection d'enveloppe, des informations d'enveloppe dans le second signal à traiter, et le fait d'entrer, par le circuit de détection d'enveloppe, les informations d'enveloppe dans le premier circuit de conversion analogique-numérique ;
l'exécution, au moyen du premier circuit de conversion analogique-numérique, d'un premier traitement de conversion analogique-numérique sur la base des informations d'enveloppe pour obtenir un signal d'enveloppe numérique ; et le fait d'entrer, par le premier circuit de conversion analogique-numérique, le signal d'enveloppe numérique dans le circuit de traitement numérique ; et
l'obtention, par le circuit de traitement numérique, sur la base du signal annulé d'interférence et du signal d'enveloppe numérique, du signal cible dans lequel le produit d'intermodulation non linéaire est annulé ;
dans lequel le procédé comprend spécifiquement :
le fait d'entrer séparément, par le circuit d'addition, un signal cible dans le circuit d'annulation et de résolution et
dans le circuit de décision ferme ;
l'exécution, par le circuit de décision ferme, d'un traitement d'élimination d'erreur sur le signal cible sur la base d'une condition de seuil prédéfinie, afin d'obtenir un signal d'erreur éliminée ; et le fait d'entrer, par le circuit de décision ferme, le signal d'erreur éliminée dans le circuit d'annulation et de résolution ;
la mise au carré, au moyen du circuit de mise au carré, d'une valeur de module du signal d'enveloppe numérique, pour obtenir un signal au carré ; et le fait d'entrer, par le circuit de mise au carré, le signal au carré dans le circuit d'annulation et de résolution ;
l'obtention, par le circuit d'annulation et de résolution, sur la base du signal au carré, du signal cible et du signal d'erreur éliminée, d'un signal d'annulation d'interférence de produit d'intermodulation utilisé pour annuler le produit d'intermodulation non linéaire, et le fait d'entrer, par le circuit d'annulation et de résolution, le signal d'annulation d'interférence de produit d'intermodulation dans le circuit d'addition ; et
l'obtention, par le circuit d'addition, sur la base du signal d'annulation d'interférence et du signal d'annulation d'interférence de produit d'intermodulation, du signal cible dans lequel le produit d'intermodulation non linéaire est annulé ;
dans lequel le filtrage du premier signal à traiter, pour obtenir un signal annulé d'interférence, comprend :
le filtrage du premier signal à traiter, pour obtenir un signal filtré ; et
l'exécution d'un traitement de réglage de puissance sur le signal filtré, et l'exécution d'un traitement de conversion analogique-numérique sur le signal filtré obtenu après le traitement de réglage de puissance, pour obtenir le signal annulé d'interférence.

8. Procédé selon la revendication 7, dans lequel l'obtention, sur la base du signal au carré, du signal cible et du signal d'erreur éliminée, d'un signal d'annulation d'interférence de produit d'intermodulation utilisé pour annuler le produit d'intermodulation non linéaire comprend :
la multiplication du signal au carré par le signal d'erreur éliminée, pour obtenir une composante d'annulation utilisée pour annuler le produit d'intermodulation non linéaire ;
l'exécution d'un traitement de résolution d'erreur sur le signal cible et le signal d'erreur éliminée, pour obtenir une valeur de coefficient de la composante d'annulation ; et
la multiplication de la valeur du coefficient de la composante d'annulation par la composante d'annulation, pour obtenir le signal d'annulation d'interférence du produit d'intermodulation utilisé pour annuler le produit d'intermodulation non linéaire.

9. Procédé selon la revendication 7, dans lequel l'obtention séparée d'un premier signal à traiter et d'un second signal à traiter sur la base d'un signal d'entrée comprend :
l'amplification du signal d'entrée, pour obtenir un signal amplifié ;
l'exécution d'un traitement de réglage de puissance sur le signal amplifié, et le réglage d'une fréquence du signal amplifié obtenu après le traitement de réglage de puissance à une plage de fréquence prédéfinie, pour obtenir un signal mixte ; et
le couplage du signal mixte, pour obtenir séparément le premier signal à traiter et le second signal à traiter.

10. Procédé selon la revendication 7, dans lequel l'obtention séparée d'un premier signal à traiter et d'un second signal à traiter sur la base d'un signal d'entrée comprend :
l'amplification du signal d'entrée, pour obtenir un signal amplifié ;
le couplage du signal amplifié pour obtenir le second signal à traiter ; et
l'exécution d'un traitement de réglage de puissance sur le second signal à traiter, et le réglage d'une fréquence du second signal à traiter obtenu après le traitement de réglage de puissance à une plage de fréquence prédéfinie, pour obtenir le premier signal à traiter.

11. Procédé selon la revendication 7, dans lequel l'obtention séparée d'un premier signal à traiter et d'un second signal à traiter sur la base d'un signal d'entrée comprend :
l'amplification du signal d'entrée, pour obtenir un signal amplifié ;
l'exécution d'un traitement de réglage de puissance sur le signal amplifié, et le couplage du signal amplifié obtenu après le traitement de réglage de puissance, pour obtenir le second signal à traiter ; et
le réglage d'une fréquence du second signal à traiter à une plage de fréquence prédéfinie, pour obtenir le premier signal à traiter.

12. Procédé selon la revendication 7, dans lequel l'obtention séparée d'un premier signal à traiter et d'un second signal à traiter sur la base d'un signal d'entrée comprend :
le couplage du signal d'entrée pour obtenir le second signal à traiter ;
l'amplification du second signal à traiter pour obtenir un signal amplifié ; et
l'exécution d'un traitement de réglage de puissance sur le signal amplifié, et le réglage d'une fréquence du signal amplifié obtenu après le traitement de réglage de puissance à une plage de fréquence prédéfinie, pour obtenir le premier signal à traiter.
